# EUROPEAN PATENT APPLICATION

(11) **EP 4 531 502 A1**
(43) Date of publication of application: **02.04.2025**
(21) Application number: 24202901.5
(22) Date of filing: 26.09.2024
(51) Int. Cl.: H05K 3/00, H05K 3/40, H05K 1/03

(54) **METHOD OF PRODUCING A SUBSTRATE**

(30) Priority: 27.09.2023 JP 2023165889; 22.11.2023 JP 2023198497; 02.04.2024 JP 2024059772
(71) Applicant: Nichia Corporation, Anan-shi, Tokushima 774-8601 (JP)
(72) Inventor: SASAOKA, Norifumi, Anan-shi, Tokushima, 774-8601 (JP); KAWAMATA, Takashi, Anan-shi, Tokushima, 774-8601 (JP)
(74) Representative: Winter, Brandl - Partnerschaft mbB

(57) **Abstract**

A method of producing a substrate (20) includes: providing a ceramic substrate (20) having a first surface (21) and a second surface (22) that is located opposite the first surface (21); irradiating a first part (201) of the first surface (21) with a first laser light (51) having a first pulse width to perform ablation of the first part (201) of the ceramic substrate (20); and irradiating a second part (202) of either the first surface (21) or the second surface (22) with a second laser light (52) having a second pulse width, which is longer than the first pulse width, the second part (202) being located apart from the first part (201) in a plan view to perform thermal processing of a third part (203) including the first part (201) and the second part (202). Upon removal of the third part (203) and a part (204) enclosed by the third part (203), an aperture (23) that extends from the first surface to the second surface is formed in the ceramic substrate (20).

## Description

### BACKGROUND

### 1. Field of the Invention

The present disclosure relates to a method of producing a substrate.

### 2. Description of the Related Art

There has been known substrates having wiring on which light-emitting elements and a variety of other electrical elements can be mounted. Also, Japanese Patent Application Publication No. 2019-511115 discloses a technique for forming a via-hole that penetrates a ceramic base material by laser processing.

### [Related-Art Document]

### [Patent Document]

[Patent Document 1] Unexamined Japanese Patent Application Publication No. 2019-511115

### SUMMARY

### [Technical Problem]

Ceramic substrates are harder than substrates made of other materials, and therefore are more difficult to process with high accuracy than substrates made of other materials. Meanwhile, high accuracy in position and shape of apertures are required for highly accurate mounting of light-emitting elements and a variety of other electrical elements on a substrate and highly accurate forming of wiring on the substrate.

Certain embodiments of the present disclosure provide a method of producing a substrate that allows accurate formation of apertures that penetrate a ceramic substrate.

### [Solution to Problem]

According to one embodiment of the present disclosure, a method of producing a substrate includes:
providing a ceramic substrate having a first surface and a second surface that is located opposite the first surface;
irradiating a first part of the first surface with a first laser light having a first pulse width to perform ablation of the first part of the ceramic substrate; and
irradiating a second part of either the first surface or the second surface with a second laser light having a second pulse width, which is longer than the first pulse width, the second part being located apart from the first part in a plan view to perform thermal processing of a third part including the first part and the second part, and,
in this method, upon removal of the third part and a part enclosed by the third part, an aperture that extends from the first surface to the second surface is formed in the ceramic substrate.

### [Advantageous Effects of the Invention]

According to certain embodiments of the present disclosure, a method of producing a substrate that allows accurate formation of apertures that penetrate a ceramic substrate can be provided.

### BRIEF DESCRIPTION OF THE DRAWINGS

FIG. 1 is a schematic top view that illustrates a structure of a light-emitting device with a substrate according to an embodiment;
FIG. 2 is a schematic cross-sectional view taken along line II-II in FIG. 1;
FIG. 3 is a schematic top view that illustrates a step of providing a ceramic substrate, which is the target of the method of producing a substrate according to the embodiment;
FIG. 4 is a schematic cross-sectional view taken along line IV-IV in FIG. 3;
FIG. 5 is a schematic top view of a ceramic substrate, illustrating a first processing step in the method of producing a substrate according to the embodiment;
FIG. 6 is a schematic cross-sectional view taken along line VI-VI in FIG. 5;
FIG. 7 is a first schematic top view of a ceramic substrate, illustrating a second processing step in the method of producing a substrate according to the embodiment;
FIG. 8 is a first schematic cross-sectional view taken along line VIII-VIII in FIG. 7;
FIG. 9 is a second schematic top view of a ceramic substrate, illustrating a second processing step in the method of producing a substrate according to the embodiment;
FIG. 10 is a second schematic cross-sectional view taken along line X-X in FIG. 9;
FIG. 11A is a schematic top view of an aperture that is formed by the method of producing a substrate according to the embodiment;
FIG. 11B is a schematic bottom view of an aperture that is formed by the method of producing a substrate according to the embodiment;
FIG. 12 is a schematic cross-sectional view taken along line XII-XII in FIG. 11A;
FIG. 13 is a schematic top view of a ceramic substrate, illustrating a second processing step in the method of producing a substrate according to a first variation;
FIG. 14 is a schematic cross-sectional view taken along line XIV-XIV in FIG. 13;
FIG. 15 is a schematic top view of a ceramic substrate, illustrating a first part that is subject to processing in the method of producing a substrate according to a second variation;
FIG. 16 is a schematic cross-sectional view taken along line XVI-XVI in FIG. 15;
FIG. 17 is a first schematic top view of a ceramic substrate, illustrating a second part and a third part that are subject to processing in the method of producing a substrate according to the second variation;
FIG. 18 is a first schematic cross-sectional view taken along line XVIII-XVIII in FIG. 17;
FIG. 19 is a second schematic top view of a ceramic substrate, illustrating a second part and a third part that are subject to processing in the method of producing a substrate according to the second variation;
FIG. 20 is a second schematic cross-sectional view taken along line XX-XX in FIG. 19;
FIG. 21A is a schematic top view of a substrate, illustrating an aperture formed by the method of producing a substrate according to the second variation;
FIG. 21B is a schematic bottom view of a substrate, illustrating an aperture formed by the method of producing a substrate according to the second variation;
FIG. 22A is a schematic cross-sectional view taken along line XXII-XXII in FIG. 21A;
FIG. 22B is a schematic cross-sectional view that illustrates a structure of a light-emitting device with a substrate according to the second variation;
FIG. 23A is a graph that shows the reflectance of a ceramic substrate and glass;
FIG. 23B is a top-view photograph of an aperture formed by the method of producing a substrate according to an example 1;
FIG. 24 is a bottom-view photograph of an aperture formed by the method of producing a substrate according to example 1;
FIG. 25 is a top-view photograph of an aperture formed by the method of producing a substrate according to an example 2;
FIG. 26 is a bottom-view photograph of an aperture formed by the method of producing a substrate according to example 2;
FIG. 27 is a top-view photograph of an aperture formed by the method of producing a substrate according to a reference example;
FIG. 28 is a bottom-view photograph of an aperture formed by the method of producing a substrate according to the reference example;
FIG. 29 is a top-view photograph of an aperture formed by the method of producing a substrate according to a comparative example;
FIG. 30 is a bottom-view photograph of an aperture formed by the method of producing a substrate according to the comparative example;
FIG. 31 is a schematic diagram for explaining the gap between a first part and a second part;
FIG. 32 is a diagram that shows the relationship between the gap between the first part and the second part and the deviation between positions of formation;
FIG. 33 shows photographs of a first surface and a second surface, taken after a first processing step and after a second processing step, respectively;
FIG. 34 is a cross-sectional view of an aperture for explaining a first example of the shape of an aperture's inner lateral surfaces; and
FIG. 35 is a cross-sectional view of an aperture for explaining a second example of the shape of an aperture's inner lateral surfaces.

### DETAILED DESCRIPTION

The method of producing a substrate according to certain embodiments of the present disclosure will be described in detail with reference to the accompanying drawings. However, the embodiments to be described below are mere examples of a method of producing a substrate for giving a concrete form to the technical idea of the present disclosure, and are not intended as limitation to the description below. Furthermore, the size, material, shape, relative positioning, and the like of the components described in the following embodiment are simply illustrative examples and are not intended to limit the scope of the present disclosure unless otherwise specified. Note that the size, positional relationship, and so forth of components shown in each drawing may be exaggerated for ease of understanding. Also, in the following description, the same names, reference numerals, and characters indicate the same or similar components, and their detailed description will be omitted as appropriate. An end view illustrating only a cut surface may be used as a cross-sectional view.

The directions in the drawings referenced in the following description may be defined by the X-axis, Y-axis, and Z-axis, which are perpendicular to each other. The X direction on the X axis and the Y direction on the Y axis are directions in which the first surface of a ceramic substrate, which is the target of the method according to the embodiments, extends. The Z direction on the Z axis is a direction that is perpendicular to the first surface. That is, the first surface of the ceramic substrate is parallel to the X-Y plane, and the Z axis is perpendicular to the X-Y plane.

A side with respect to the X direction in which an arrow points in each drawing will be represented as "+X side," and a side opposite to the +X side will be represented as "-X side."

A side with respect to the Y direction in which an arrow points in each drawing will be represented as "+Y side," and a side opposite to the +Y side will be represented as "-Y." A side with respect to the Z direction in which an arrow points in each drawing will be represented as "upper" or "+Z side," and a side opposite to the +Z side will be represented as "-Z."

In the following embodiments, the term "plan view" will be used when viewing an object from the +Z side or the -Z side. In the embodiments, the surface of an object viewed from the +Z side will be referred to as the "upper surface," and the surface of an object viewed from the -Z side will be referred to as the "lower surface." Among the surfaces of a ceramic substrate, which is the target of the method of the embodiment, the upper surface will be referred to as "the first surface," and the lower surface will be referred to as "the second surface." These terminologies do not limit orientations of components or the like when implementing the method of producing a substrate according to the embodiment. In the following embodiment, the expression that an object is along the X-axis, the Y-axis, or the Z-axis encompasses a case in which the object is tilted within a range of ±10 degrees with respect to a corresponding one of these axes. The term "orthogonal" in the following embodiment may encompass a deviation within ±10 degrees with respect to a right angle (90 degrees).

Also, in the specification or claims, when a plurality of the same components are provided and need to be identified such that these components are distinguished from each other, the prefix "first," "second," or the like may be given before the name of each component. Also, there may be instances in which an object that is identified varies between the specification and claims. That is, even if a component recited in a claim is preceded by a prefix that is the same as one used in the specification, the same prefix might be used to identify different objects in the specification and claims.

For example, assuming that components labeled "first", "second", and "third" are present in the present description and that the components labeled "first" and "third" in the present description are to be recited in the claims, these components may be labeled "first" and "second" in the claims for ease of understanding. Also, assuming that components labeled "first", "second", and "third" are present in the present description and that the component labeled "first" and a component denoted without any specific ordinal number in the present specification are to be recited in the claims, these components may be labeled "first" and "second" in the claims for ease of understanding. In such cases, the components labeled "first" and "second" in claims may refer to the components labeled "first" and "third" in the specification, or to the component not labeled with a specific ordinal number or expression. Note that this rule is not only applied to components and elements, but also expands, reasonably and flexibly, to a variety of other objects as well.

### EMBODIMENT

### EXAMPLE STRUCTURE OF LIGHT-EMITTING DEVICE 100 WITH SUBSTRATE 2

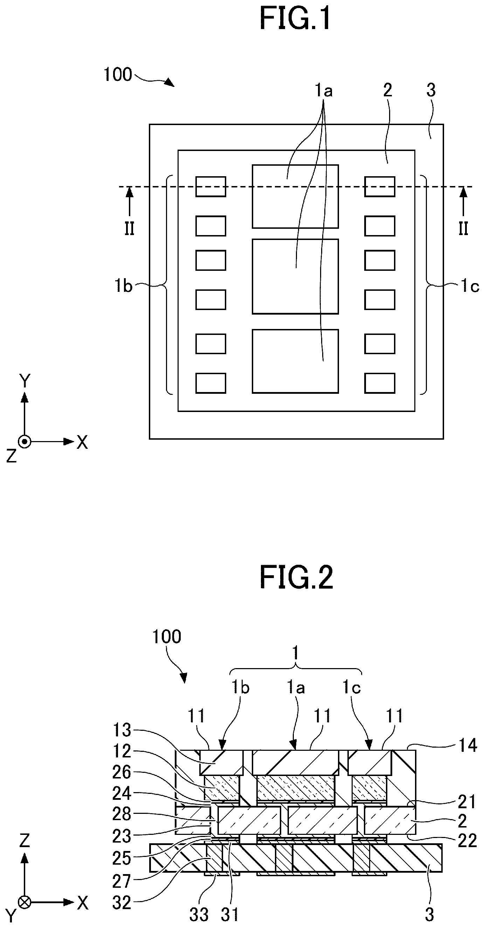

First, the structure of a light-emitting device with a substrate according to one embodiment of the present disclosure will be described with reference to FIG. 1 and FIG. 2. In the examples illustrated in FIG. 1 and FIG. 2, an example case in which a substrate containing a ceramic is used in a light-emitting device will be described. FIG. 1 is a schematic top view that illustrates an example structure of a light-emitting device 100 including a substrate 2. FIG. 2 is a schematic cross-sectional view taken along line II-II in FIG. 1.

As illustrated in FIG. 1 and FIG. 2, the light-emitting device 100 has multiple light emitting parts 1, a substrate 2, and a mounting substrate 3. The light-emitting parts 1 are all positioned on a surface of the substrate 2 at the +Z side. The substrate 2 is placed on the a surface of the mounting substrate 3 at the +Z side.

In the examples illustrated in FIG. 1 and FIG. 2, the light-emitting device 100 includes fifteen light-emitting parts 1. Also, these fifteen light-emitting parts 1 include three light-emitting parts 1a, six light-emitting parts 1b, and six light-emitting parts 1c. As illustrated in FIG. 1, each of the fifteen light-emitting parts 1 has a substantially rectangular shape in a plan view. The area of a light-emitting part 1b is equal to the area of a light-emitting part 1c. The area of a light-emitting part 1a is larger than the area of a light-emitting part 1b or 1c. In a plan view, the six light-emitting parts 1b are arrayed in the Y direction, on the -X side of the three light-emitting parts 1a. Similarly, in a plan view, the six light-emitting parts 1c are arrayed in the Y direction, on the +X side of the three light-emitting parts 1a. For the plurality of light-emitting parts 1, combination of light-emitting parts 1 of different numbers and/or areas, a shape of each of the light-emitting parts 1 in a plan view, arrangement of the light-emitting parts 1 in a plan view positioning, etc., can be changed as appropriate.

The light-emitting parts 1 is preferably configured to emit white light, and may be configured to emit monochromatic light. The wavelength of light emitted by the light-emitting parts 1 can be selected as appropriate depending on the usage of the light-emitting device 100.

As illustrated in FIG. 2, the light-emitting parts 1 are mounted on a surface of the substrate 2 at the +Z surface, that is, on a first surface 21 such that a surface of each of the light-emitting parts 1 at +Z side serves as a light-emitting surface 11 and a surface opposite thereto serves as a mounting surface. A light-emitting part 1 includes: a light-emitting element 12; a light-transmissive member 13 provided on the surface of the light-emitting element 12 at the +Z side; and a cover member 14 that covers lateral surfaces of the light-emitting element 12 and the lateral surfaces of the light-transmissive member 13, except for a surface of the light-transmissive member 13 at the +Z side. The fifteen light-emitting parts 1 are all structured alike.

It is preferable to provide at least a pair of positive and negative electrodes on the surface of each of the light-emitting elements 12 that is opposite to the light-emitting surface 11. In the examples illustrated in FIG. 1 and FIG. 2, the shape of each light-emitting surface 11 is substantially rectangular in a plan view. However, each light-emitting surface 11 may have a substantially round or elliptical shape in a plan view, or may have a substantially polygonal shape, such as substantially triangular or hexagonal shape, in a plan view.

Each light-emitting element 12 may include a variety of semiconductors such as a III-V compound semiconductor, a II-VI compound semiconductor, and so forth. The light-emitting elements 12 may be light-emitting diodes (LEDs) or laser diodes (LDs). As the semiconductors, a nitride-based semiconductor such as In_{X}Al_{Y}Ga_{1-X-Y}N (0≦X, 0≦Y, and X+Y≦1) is preferably used, and InN, AlN, GaN, InGaN, AlGaN, InGaAlN, etc., can be used. In consideration of luminous efficiency, the excitation of the wavelength-converting substance (described later), and mixing of colors of light emitted by the light-emitting element 12 and light emitted by the wavelength-converting substance, the peak wavelength of light emitted by the light-emitting element 12 is preferably between 400 nm and 530 nm, inclusive, more preferably between 400 nm and 490 nm, inclusive, and even more preferably between 440 nm and 475 nm, inclusive.

Each light-transmissive member 13 is, for example, a substantially rectangular member in a plan view, and positioned to cover the upper surface of the light-emitting element 12. The light-transmissive member 13 can be formed using a light-transmissive resin material or an inorganic material such as ceramic or glass. For the resin material, a thermosetting resin such as a silicone resin, a silicone-modified resin, an epoxy resin, an epoxy-modified resin, or a phenol resin can be used. In particular, a silicone resin or a modified resin derived therefrom has excellent light resistance and heat resistance, and is suitable for use. The term "light-transmissive" in the present specification preferably means being configured to transmit 60% or more of the light emitted from the light-emitting element 12. Also, for the light-transmissive member 13, a thermoplastic resin such as a polycarbonate resin, an acrylic resin, a methylpentene resin, or a polynorbornene resin can be used. Furthermore, the light-transmissive member 13 may contain a light-diffusing substance, or a wavelength-converting substance that converts the wavelength of at least part of the light emitted from the light-emitting element 12. For example, the light-transmissive member 13 may be a resin material, ceramic, glass, or the like containing a wavelength-converting substance, or may be a sintered body of a wavelength-converting substance. Furthermore, the light-transmissive member 13 may be a multi-layer member in which a resin layer containing a wavelength-converting substance, a light-diffusing substance and the like is laid on surfaces of a molded body of resin, ceramic, glass, or the like at the ±Z sides.

Examples of the wavelength-converting substance include yttrium aluminum garnet-based phosphor (for example, (Y, Gd)₃(Al, Ga)₅O₁₂: Ce); lutetium aluminum garnet-based phosphor (for example, Lu₃ (Al, Ga)₅O₁₂: Ce); terbium aluminum garnet-based phosphor (for example, Tb₃(Al, Ga)₅O₁₂: Ce); CCA-based phosphor (for example, Ca₁₀(PO₄)₆Cl₂: Eu); SAE-based phosphor (for example, Sr₄Al₁₄O₂₅: Eu); chlorosilicate-based phosphor (for example, Ca₈MgSi₄O₁₆Cl₂: Eu); silicate-based phosphor (for example, (Ba, Sr, Ca, Mg)₂SiO₄: Eu); oxynitride-based phosphors such as β-sialon-based phosphor (for example, (Si, Al)₃(O,N)₄: Eu) and α-sialon-based phosphor (for example, Ca(Si, Al)₁₂(O, N)₁₆: Eu); nitride-based phosphors such as LSN phosphor (for example, (La, Y)₃Si₆N₁₁: Ce), BSESN-based phosphor (for example, (Ba, Sr)₂Si₅N₈: Eu), SLA-based phosphor (for example, SrLiAl₃N₄: Eu), CASN-based phosphor (for example, CaAlSiN₃: Eu), and SCASN-based phosphor (for example, (Sr, Ca)AlSiN₃: Eu); fluoride-based phosphors such as KSF-based phosphor (for example, K₂SiF₆: Mn), KSAF-based phosphor (for example, K₂(Si₁₋ₓAlx)F₆₋ₓ: Mn, where x satisfies 0<x<1), and MGF-based phosphor (for example, 3.5MgO·0.5MgF₂· GeO₂: Mn); and quantum dots such as a quantum dot of perovskite structure (for example, (Cs, FA, MA) (Pb, Sn)(F, Cl, Br, I)₃, where FA and MA are formamidinium and methylammonium, respectively), a II-VI quantum dot (for example, CdSe), a III-V quantum dot (for example, InP), and a quantum dot of chalcopyrite structure (for example, (Ag, Cu) (In, Ga) (S, Seh) .

In the examples illustrated in FIG. 1 and FIG. 2, in each light-emitting part 1, a blue LED is used as the light-emitting element 12, and the wavelength-converting substance contained in the light-transmissive member 13 converts the wavelength of a part of the blue light emitted from the light-emitting element 12 to yellow, and the blue light and the yellow light are mixed to emit white light. The light-diffusing substance contained in the light-transmissive member 13 may be, for example, titanium oxide, barium titanate, aluminum oxide, silicon oxide, or the like.

The cover member 14 is arranged to cover the lateral surfaces of the light-emitting elements 12 and the lateral surfaces of the light-transmissive members 13. The cover member 14 covers the lateral surfaces of the light-emitting element 12 and the lateral surfaces of the light-transmissive members 13 directly or indirectly. The upper surface of each light-transmissive member 13 is exposed from the cover member 14 and forms the light-emitting surface 11 of a corresponding light-emitting part 1. In the examples illustrated in FIG. 1 and FIG. 2, the cover member 14 is positioned between adjacent ones of light-emitting parts 1 and collectively covers the fifteen light-emitting parts 1. The cover member 14 may be separated between adjacent light-emitting parts among the fifteen light-emitting parts 1. The cover member 14 is preferably a member having a high light reflectance to improve light extraction efficiency. For the cover member, for example, an organic material such as a resin with a light-reflecting substance, such as a white pigment, contained therein can be used. Also, the cover member 14 may be a light-reflective member made of an inorganic material including, for example, boron nitride and alkali metal silicate. In this case, the cover member 14 may further contain titanium oxide or zirconium oxide.

Examples of light-reflecting substances include titanium oxide, zinc oxide, magnesium oxide, magnesium carbonate, magnesium hydroxide, calcium carbonate, calcium hydroxide, calcium silicate, magnesium silicate, barium titanate, barium sulfate, aluminum hydroxide, aluminum oxide, zirconium oxide, and silicon oxide.

It is preferable to use one of these substances alone, or use two or more of these substances in combination. A resin material whose main component is a thermosetting resin such as an epoxy resin, an epoxy-modified resin, a silicone resin, a silicone-modified resin, or a phenol resin is preferably used as a base material of the resin material being the organic material. If necessary, the cover member 14 may be made of a material that is transmissive or absorptive of visible light.

The substrate 2 is a flat member that has a substantially rectangular shape in a plan view. The substrate 2 is made of a material such as silicon nitride, silicon carbide, aluminum nitride, aluminum oxide, and so forth. The shape of the substrate 2 in a plan view is not limited to being substantially rectangular, and may be substantially round, substantially elliptical, substantially polygonal, etc.

The substrate 2 is made of a ceramic substrate 20, as will be described later, and has a first surface 21 and a second surface 22 that is located opposite to the first surface 21. In the example illustrated in FIG. 2, the substrate 2 has at least a pair of positive and negative first electrodes 24 positioned on the first surface 21, and at least a pair of positive and negative second electrodes 25 positioned on the second surface 22. In addition, multiple apertures 23 are formed in the substrate 2, extending from the first surface 21 to the second surface 22. The apertures 23 are via-holes, for example.

The substrate 2 includes first electrodes 24 and second electrodes 25 such that a respective first electrode 24 and a respective second electrode 25 correspond to a respective one of the fifteen light-emitting parts 1. Also, in the substrate 2, each aperture 23 is formed for a respective one of the fifteen light-emitting parts 1. Each first electrode 24 is electrically connected to a light-emitting element 12 via a first conductive bonding member 26. Each second electrode 25 is electrically connected, via a second conductive bonding member 27, to a corresponding one of a pair of positive and negative third electrodes 31 positioned on the upper surface of the mounting substrate 3. Each of the first electrodes 24 and a respective one of the second electrodes 25 are electrically connected via a respective one of conductive members 28. Each of the first electrodes 24 of the substrate 2 and a respective one of the electrodes of the light-emitting elements 12 are connected via a respective one of the first conductive bonding members 26, thereby electrically connecting the substrate 2 and the light-emitting parts 1.

Each conductive member 28 is made of a sintered conductive paste containing a conductive material, and positioned in an aperture 23. For example, when the ceramic substrate 20 contains silicon nitride, the conductive paste preferably contains at least one of Ti, Hf, Zr, Nb, Ce, or Mg. From the perspective of the wettability and light reflectivity of the first conductive bonding member 26 and the second conductive bonding member 27, a layer of Ag, Pt, Al, Rh, Au or an alloy of these may be formed on the surface of each conductive member 28. In the substrate 2, the structure, size, and the like of the apertures 23, in which the conductive members 28 are positioned, are set as appropriate in accordance with the structure, size, and the like of the first electrodes 24 and second electrodes 25 of the light-emitting parts 1.

The mounting substrate 3 is a flat member that is substantially rectangular in shape in a plan view. The mounting substrate 3 has wiring 32 formed on its surfaces (the surface at the +Z side and a surface at the -Z side). The mounting substrate 3 may also have wiring 32 inside. In the examples illustrated in FIG. 2, the mounting substrate 3 includes the wiring 32 formed inside, the third electrodes 31 provided on the surface of the mounting substrate 3 at +Z side and connected to the wiring 32, and the fourth electrodes 33 provided on the surface of the mounting substrate 3 at the -Z side and connected to the wiring 32. In the mounting substrate 3, each of the second electrodes 25 of the substrate 2 and a respective one of the third electrodes 31 of the mounting substrate 3 are connected via a respective one of the second conductive bonding members 27, thereby electrically connecting the substrate 2 and the mounting substrate 3. The structure, size, and the like of the wiring 32 of the mounting substrate 3 are designed in accordance with the structure, size, and the like of the second electrodes 25 of the substrate 2. Also, the shape of the mounting substrate 3 in a plan view is not limited to being substantially rectangular, and may be substantially round, substantially elliptical, substantially polygonal, or the like.

For the mounting substrate 3, an insulating material as its base material, and a material that is less likely to transmit light emitted from the light-emitting parts 1 and external light and a material that has a certain strength are preferably used. To be more specific, the mounting substrate 3 can be formed using ceramics such as aluminum oxide, aluminum nitride, mullite, and silicon nitride, or a resin such as phenol resin, epoxy resin, polyimide resin, BT resin (bismaleimide triazine resin), and polyphthalamide, as a base material.

### EXAMPLE METHOD OF PRODUCING SUBSTRATE ACCORDING TO EMBODIMENT

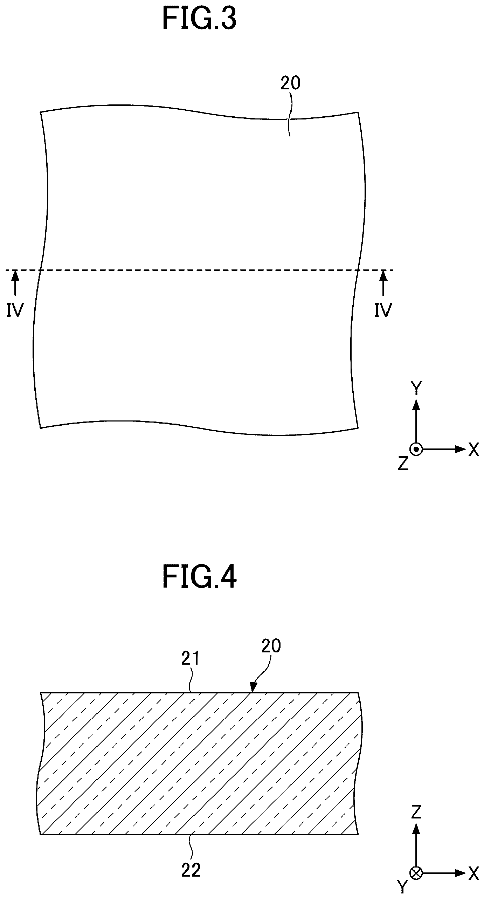

Next, the method of producing a substrate according to the embodiment will be described with reference to FIG. 3 to FIG. 12. The method according to the embodiment is, for example, a method of producing the substrate 2 illustrated in FIG. 1 and FIG. 2.

The method of producing the substrate 2 according to the embodiment includes: (a) a step of providing a ceramic substrate 20 having a first surface 21 and a second surface 22; and (b) a first processing step of irradiating a first part of the first surface 21 with a first laser light having a first pulse width to ablate the first part of the ceramic substrate 20. The method of producing the substrate 2 according to the embodiment further includes (c) a second processing step of irradiating a second part of either the first surface 21 or the second surface 22 with a second laser light having a second pulse width, which is longer than the first pulse width, the second part being located apart from the first part in a plan view, to perform thermal processing of a third part including the first part and the second part. In this method of producing the substrate 2 according to the embodiment, upon removal of the third part and the part enclosed by the third part by the second processing step, an aperture that penetrates from the first surface to the second surface is formed in the ceramic substrate 20.

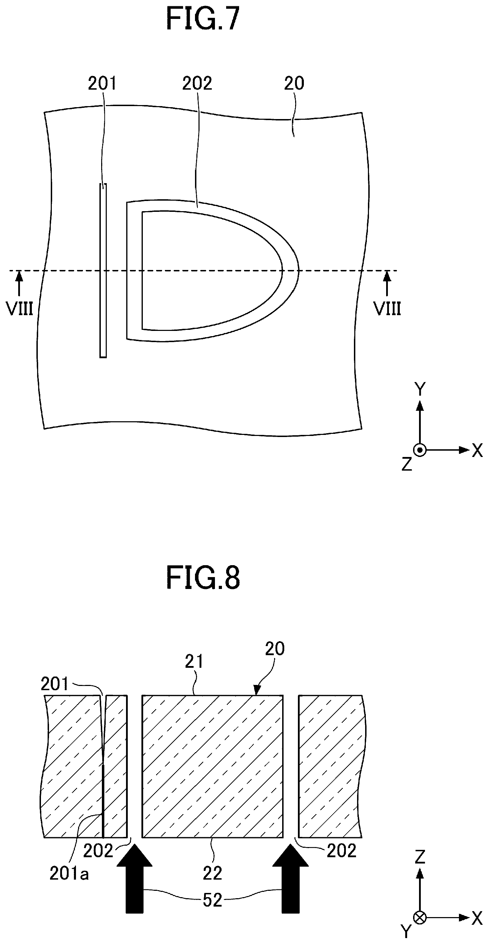

According to the present embodiment, ablation, which is processing that has very small thermal impact, is performed in the first processing step, so that the portion of the ceramic substrate 20 where the irradiated first laser light 51 is absorbed can be removed mainly by sublimation. According to the present embodiment, ablation refers to processing that does not involve thermal fusion. This can reduce the impact of heat produced by laser light and enable high-accuracy processing. According to the present embodiment, it is possible to provide a method of producing a substrate that allows for highly accurately processing desired parts such as the first part and other parts with high accuracy by ablation and thus highly accurately forming an aperture 23 that extends through the ceramic substrate 20. On the other hand, using ablation allows for reducing impact of heat, which may result in longer processing time compared to thermal processing. However, according to the present embodiment, the thermal processing of the second processing step causes the part of the ceramic substrate 20 affected by the heat to be removed from the second laser light 52 mainly by melting, and the third part is processed more efficiently than in the first processing step. This allows the overall processing time of the aperture 23 to be shortened, which can improve the productivity of the substrate 2. The term "accuracy" in the present disclosure refers to at least one of the accuracy of positioning or the accuracy of shaping. The working and advantages of the method of producing a substrate according to the present embodiment will be described later with reference to FIG. 7 to FIG. 12. Now, each of these steps will be described in detail below.

### (a) STEP OF PROVIDING CERAMIC SUBSTRATE 20

FIG. 3 is a schematic top view of a ceramic substrate, illustrating a step of providing a ceramic substrate 20, which is the target of the method of producing a substrate according to the embodiment. FIG. 4 is a schematic cross-sectional view taken along line IV-IV in FIG. 3.

In the examples illustrated in FIG. 3 and FIG. 4, the ceramic substrate 20 provided in this process has a first surface 21 and a second surface 22 located opposite the first surface 21, and is a flat member at which apertures 23, first electrodes 24, second electrodes 25, or the like are not formed. The first surface 21 and the second surface 22 of the ceramic substrate 20 correspond to the first surface 21 and the second surface 22 of the substrate 2, which have been described earlier. Furthermore, the ceramic substrate 20 may have wiring on the first surface 21 and the second surface 22, and in at least part of its inside. If the ceramic substrate 20 is too thick, it may be difficult to form the aperture 23 therein. Therefore, the thickness of the ceramic substrate 20 is preferably between 100 um and 500 um, inclusive.

### (b) FIRST PROCESSING STEP OF ABLATING THE FIRST PART

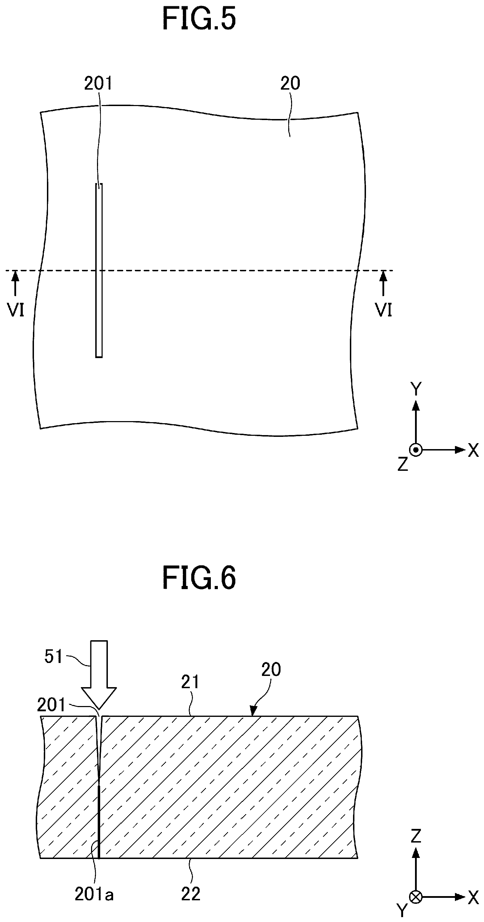

FIG. 5 is a schematic top view of a ceramic substrate, illustrating the first processing step in the method of producing a substrate according to the embodiment. FIG. 6 is a schematic cross-sectional view taken along line VI-VI in FIG. 5.

As illustrated in FIG. 5 and FIG. 6, in this step, the first laser light 51 having a first pulse width is irradiated onto the first part 201 of the first surface 21 to ablate the first part 201 in the ceramic substrate 20. In the examples illustrated in FIG. 5 and FIG. 6, in a plan view, the first part 201 is a straight, substantially rectangular part formed in a continuous manner such that its longitudinal direction runs in the Y direction. The first part 201 undergone the ablation is an aperture that has a bottom and that does not extend from the first surface 21 to the second surface 22 in the Z direction. The first part 201 not only occupies a space in the X-Y plane, but also occupies a space in the Z direction. In the method of producing a substrate according to the embodiment, the first part 201 can be ablated by irradiating the first laser light 51 onto the first surface 21 of the ceramic substrate 20, while changing the relative position between the position on which the first laser light 51 is irradiated and the ceramic substrate 20.

The shape of the first part 201 in a plan view is not limited to being substantially rectangular. For example, in the first processing step, in a plan view, the first part 201 may have a substantially circular or elliptical annular shape; an annular shape having outer edges including straight lines and curved lines, such as a substantially semi-circular annular shape, a substantially sectorial annular shape, or a substantially semi-elliptical annular shape; or a polygonal annular shape, such as a substantially square annular shape or a substantially polygonal annular shape.
The first part 201 of such an annular shape may be hereinafter referred to as "annular part."
The annular part may be either continuous or intermittent in shape. In the first processing step, the first part 201 to undergo ablation includes a portion that has been removed mainly by sublimation, and also includes an altered portion surrounding the removed portion or extending in the depth direction from the removed portion. The "altered" portion has multiple microcracks. In ablation, a portion of the first part 201 is removed, which causes a sudden change in the volume of ceramic and a residual stress that results from the change of volume. The microcracks are generated by these mechanical changes. The portion that is removed primarily by sublimation does not reach the second surface in the Z direction. In the Z direction, the altered portion of the ceramic substrate 20 may penetrate from the first surface 21 to the second surface 22. With the first part 201 extended from the first surface 21 to the second surface 22, smoother inner lateral surfaces can be formed in the aperture 23, from the first surface 21 to the second surface 22.

Ablation allows high-accuracy processing compared to thermal processing. Meanwhile, ablation may require a longer processing time than thermal processing. Accordingly, in portions of the apertures 23 where particularly high accuracy is required, it is preferable to form the first part 201 by ablation.

In ablation using the first laser light 51, the first pulse width of the first laser light 51 can be set either in a femto-second range or in a picosecond range.

A fiber laser, a titanium sapphire laser, or the like can be used as a light source that emits the first laser light 51. To improve the accuracy of processing, the first pulse width of the first laser light 51 is preferably in a femto-second range, more preferably between 1 femto-second and 10 pico-seconds, inclusive.

In the examples illustrated in FIG. 5 and FIG. 6, the maximum width of the first part 201 in the X direction is approximately 20 um. In the first part 201, the ceramic surface on which the first laser light 51 is irradiated is removed. The ceramic in the first part 201 may be removed by irradiating it with the first laser light 51 once, or removed by irradiating it with the first laser light 51 multiple times. In the example illustrated in FIG. 6, the ceramic substrate 20 has, in the first part 201, a V-shaped recess, the depth of which in the Z direction is between approximately 30 um and approximately 50 um, inclusive, and in which the ceramic is removed. The first part 201 is ablated thus, which involves no thermal fusion of ceramics, so that, for example, the width of a portion subjected to the processing in the X direction is smaller than in the thermal processing described later. Also, around the first part 201, the width of the portion where the properties of the ceramic substrate 20 are altered by ablation is approximately one tenth smaller than in processing that involves thermal fusion.

In the examples illustrated in FIG. 5 and FIG. 6, an altered portion 201a is formed on the -Z side of the first part 201, that is, on the side of the ceramic substrate 20 opposite the side irradiated with the first laser light 51. The altered portion 201a is a portion of the ceramic substrate 20 where the properties of the ceramic substrate 20 are altered by being irradiated with first laser light 51. The altered portion 201a extends from the lower end of the V-shaped recess in the first part 201 to the -Z side, and reaches a surface of the ceramic substrate 20 at the -Z side. The terms "altered" in this specification refers to a state in which the strength of the material is decreased by 30% to 50%, inclusive, from its original value.

### (c) A SECOND PROCESSING STEP OF THERMALLY PROCESSING THE THIRD PART BY IRRADIATING THE SECOND PART WITH THE SECOND LASER LIGHT

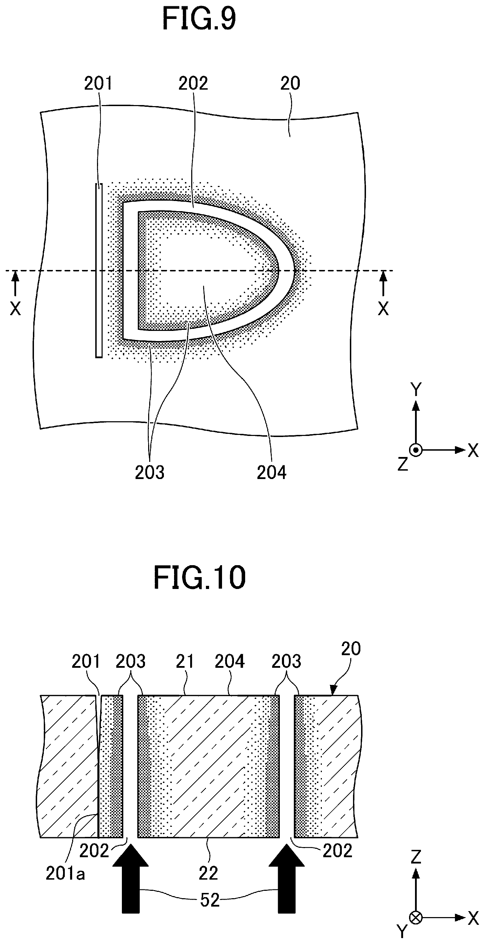

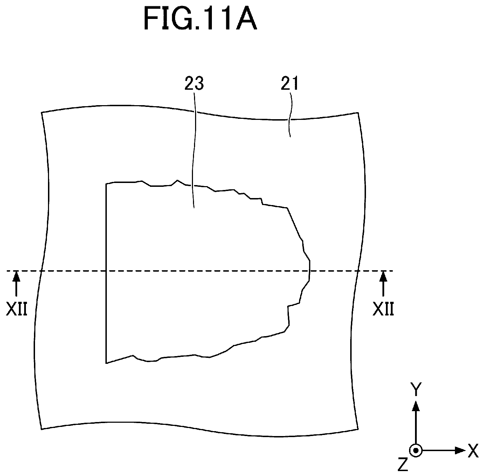

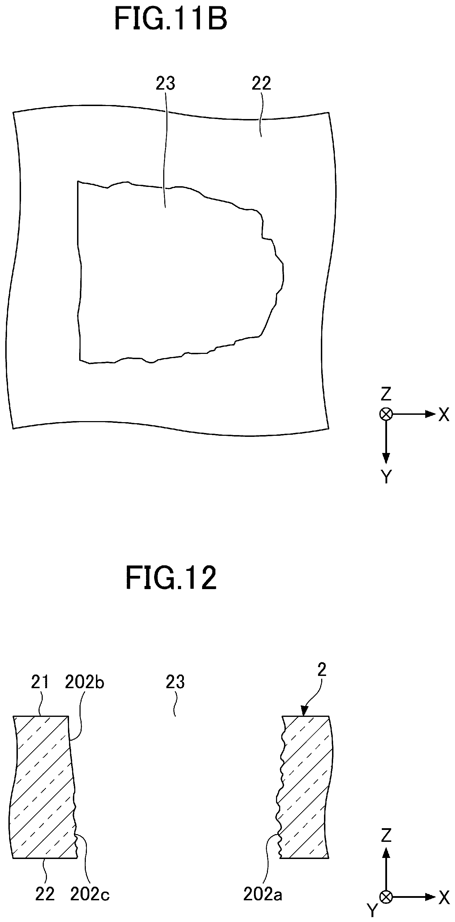

FIG. 7 is a first schematic top view of the ceramic substrate 20, illustrating a second processing step in the method of producing a substrate according to the embodiment. FIG. 8 is a first schematic cross-sectional view taken along line VIII-VIII in FIG. 7. FIG. 9 is a second schematic top view of the ceramic substrate 20, illustrating the second processing step in the method of producing a substrate according to the embodiment. FIG. 10 is a second schematic cross-sectional view taken along line X-X in FIG. 9. FIG. 11A is a schematic top view of an aperture that is formed by the method of producing a substrate according to the embodiment. FIG. 11B is a schematic bottom view of an aperture that is formed by the method of producing a substrate according to the embodiment. FIG. 12 is a schematic cross-sectional view taken along line XII-XII in FIG. 11A.

In the second processing step, the second laser light 52 having a second pulse width, which is longer than the first pulse width, is irradiated to a second part 202 located apart from the first part 201 on either the first surface 21 or the second surface 22 in a plan view to thermally process a third part 203 including the first part 201 and the second part 202. In the present embodiment, a continuous wave is obtained by maximizing the pulse width of the second pulse width in the pulse repetition period, and the second pulse width includes continuous waves. As illustrated in FIG. 11A, FIG. 11B, and FIG. 12, in the second processing step, removal of the third part 203 and a fourth part 204, which is enclosed by the third part 203 results in an aperture 23 that extends from the first surface 21 to the second surface 22. When the part enclosed by the second part 202 is small, the third part 203 alone may form the part enclosed by the second part 202. In this case, an aperture 23 that penetrates from the first surface 21 to the second surface 22 can be formed by removing the third part 203 alone.

A case will be described below with the present embodiment in which the second laser light 52 is emitted from the second surface 22 side. As illustrated in FIG. 7 to FIG. 10, in the second processing step, the second laser light 52 is irradiated on the second part 202 from the second surface 22 side. In the examples illustrated in FIG. 7 and FIG. 8, in a plan view, the second laser light 52 is irradiated on the second part 202, which is located apart from the first part 201 on the second surface 22. That is, the second part 202 is located on the second surface 22. Also, in a plan view, the second part 202 is an annular part of a substantially semi-elliptical shape, which is obtained by cutting an ellipse, whose longitudinal direction coincides with the X direction, substantially in half in the longitudinal direction. The second part 202 not only occupies a space in the X-Y plane, but also occupies a space in the Z direction. The method of producing a substrate according to the embodiment allows the second laser light 52 to be irradiated on the second surface 22 of the ceramic substrate 20, while changing the relative position between the position on which the second laser light 52 is irradiated and the ceramic substrate 20.

In the ceramic substrate 20 irradiated with the second laser light 52, the heat produced by the irradiated second laser light 52 is not only present in the second part 202, but also spreads from the second part 202 to its surroundings.

In the second part 202, the ceramic is mainly melted and removed. In the examples illustrated in FIG. 7 to FIG. 10, the width of the second part 202 in the X direction is between approximately 50 um and approximately 60 um, inclusive. In the second part 202, the second laser light 52 is emitted multiple times, so that the ceramic is gradually removed. Note that, in the second part 202, the ceramic may be removed in one step by emitting the second laser light 52 once.

Meanwhile, near the second part 202 on which the second laser light 52 is not irradiated, the properties of the ceramic substrate 20 are altered due to heat (hereinafter expressions such as "thermally altered," "thermal alteration," etc. may be used). In the examples illustrated in FIG. 9 and FIG. 10, the third part 203 is a part, near the second part 202, where the second laser light 52 is not irradiated, and the properties of the ceramic substrate 20 are thermally altered. In the third part 203, the properties of the ceramic substrate 20 are thermally altered, causing the mechanical strength of the third part 203 to decrease and producing the substrate brittle. The mechanical strength of the third part 203 decreases gradually toward the second part 202. In the examples illustrated in FIG. 9 and FIG. 10, the third part 203 where the properties of the ceramic substrate 20 are thermally altered is represented by dotted hatching, in which higher density of dots (narrower intervals between neighboring dots) indicates lower mechanical strength. As used herein, "thermal processing" of the ceramic substrate 20 includes removal of the ceramic, mainly due to melting, of the part irradiated with the second laser light 52, and thermal alteration of the properties of the ceramic around the part irradiated with the second laser light 52.

In the second processing step, in the ceramic substrate 20, the part around the fourth part 204, enclosed by the third part 203 where the mechanical strength is reduced, can be separated from the outside of the third part 203 (that is, from the part where the mechanical strength is not reduced). Subsequently, by applying a slight vibration or impact such as lifting up the ceramic substrate 20, the substrate 2 from which the part enclosed by the third part 203 is removed can be obtained. The part separated from the ceramic substrate may include a part of the third part 203. In the examples illustrated in FIG. 9 and FIG. 10, the fourth part 204 is entirely enclosed by the third part 203. Accordingly, as illustrated in FIG. 11A, FIG. 11B, and FIG. 12, upon removal of the fourth part 204, the aperture 23 extending from the first surface 21 to the second surface 22 can be formed. In the examples illustrated in FIG. 11A, FIG. 11B, and FIG. 12, the shape of the aperture 23 is substantially semi-elliptical in a plan view.

The mechanical strength is not uniform across the entire third part 203. Accordingly, separation of the part enclosing the fourth part 204 from the outer part of the third part 203 (where the mechanical strength is not reduced) results in irregularity in location of edges of the part that has enclosed the fourth part 204 and from which the fourth part 204 has been removed. Formation of irregular edges of the part that has enclosed the fourth part 204 results in roughness of the inner lateral surfaces of the aperture 23. In the example illustrated in FIG. 12, the inner lateral surfaces of the aperture 23 are rough except for the part in the first part 201 where the V-shaped recess is formed, and a rough portion 202a and a rough portion 202c are formed. In the rough portion 202a, the inner lateral surface of the aperture 23 is less smooth than in the rough portion 202c.

According to the present embodiment, the formation of edges at irregular locations in the part from which the fourth part 204 is separated has relatively less impact on the part where the first part 201 is formed among the inner lateral surfaces of the aperture 23. Also, as described earlier, around the part where the first part 201 is formed, the part where the properties of the ceramic substrate 20 are altered is smaller than around the second part 202. Therefore, among the inner lateral surfaces of the aperture 23, a smooth portion 202b, which corresponds to the V-shaped recess in the first part 201, has a smooth surface. In the smooth portion 202b, the inner lateral surface of the aperture 23 has a higher smoothness. Also, the surface roughness of the rough portion 202c in the first part 201 can be reduced. In the example illustrated in FIG. 11A, in the part where the first part 201 is formed, the contour of the aperture 23 seen from the first surface 21 is a substantially straight line, which is close to the designed straight-line shape, and thus is processed with high accuracy. On the other hand, the part where the second part 202 is formed, compared to the designed semi-elliptical shape, has multiple bent and curved lines although its overall shape is like a semi-elliptical shape, and thus is processed in a shape that is hardly regarded as being accurate. In the example illustrated in FIG. 11B, in the part where the first part 201 is formed, the contour of the aperture 23 seen from the second surface 22 is close to the designed straight-line shape, and thus is processed with relatively high accuracy. On the other hand, as in FIG. 11A, the part where the second part 202 is formed, compared to the designed semi-elliptical shape, has multiple bends and curved lines although its overall shape is semi-elliptical, and thus is processed in a shape that is hardly regarded as being accurate.

Also, in the examples illustrated in FIG. 11A and FIG. 12, the area of the first part 201 subject to ablation is smaller than the area of the second part 202 and the third part 203 subject to thermal processing. Therefore, the processing time is shortened compared to when the entire annular part of the aperture 23 is subject to ablation.

As described earlier, the method of producing a substrate according to the present embodiment can form apertures 23 in a short time compared to when the entire annular part of each aperture 23 is ablated, and form the aperture 23 with improved accuracy in desired parts such as the smooth portion 202b. The position, size, quantity or number, and so forth of the smooth portion 202b in each aperture 23 can be changed as appropriate depending on the location where the conductive member 28 is intended to be formed. The smaller the size of the smooth portion 202b in the aperture 23, or the fewer the number of smooth portions 202b, the shorter the processing time of the apertures 23 can be.

Also, in the second processing step in the method of producing a substrate according to the embodiment, the second part 202 has an annular shape. This allows formation of apertures 23 that penetrate the third part 203 and the fourth part 204 from the first surface 21 to the second surface 22. Accordingly, the apertures 23 can be formed more efficiently than when the second laser light 52 is emitted onto both the second part 202 and the fourth part 204.

The shape of the second part 202 in a plan view is not limited to being substantially semi-elliptical. For example, in the second processing step, the second part 202 may have a substantially circular or elliptical annular shape; an annular shape having outer edges including straight lines and curved lines, such as a substantially semi-circular annular shape, a substantially sectorial annular shape, or a substantially semi-elliptical annular shape; or a polygonal annular shape, such as a substantially square annular shape or a substantially polygonal annular shape. The second part 202 of such an annular shape may be hereinafter referred to as "annular part." The annular part has a continuous third part 203, and the second part 202 may be formed either continuous or discontinuous in shape. As long as the thermal alteration of the properties of the ceramic substrate 20 in the third part 203 is continuous from the first surface 21 to the second surface 22 in the Z direction, the thermal alteration of the properties of the ceramic substrate 20 in the second part 202 is not necessarily continuous from the first surface 21 to the second surface 22. The third part 203 is a part that extends outward from the second part 202 to its surroundings, and therefore is shaped similarly to both the inner side and the outer side of the annular shape of the second part 202 in a plan view.

Thermal processing using the second laser light 52 can be performed by the second laser light 52 having the second pulse width longer than the first pulse width, that is, the second pulse width greater than or equal to a nano-second range.

A CO₂ laser light source or the like can be used as the light source that emits the second laser light 52. According to the present embodiment, the second laser light 52 is a laser light emitted from a CO₂ laser light source. From the perspective of improving the efficiency of processing, the second pulse width of the second laser light 52 is preferably between 700 nanoseconds and 70 microseconds, inclusive.

The method of producing a substrate according to the present embodiment may further include a conductive member forming step of placing a conductive paste in each aperture 23 and firing the conductive paste to form each conductive member 28 illustrated in FIG. 2. By including the above conductive member forming step in the method of producing a substrate according to the present embodiment, the light-emitting elements and a variety of electrical elements positioned on the substrate 2 can be electrically connected to the substrate 2.

For example, when the ceramic substrate 20 is made of silicon nitride, the conductive paste preferably contains at least one of Ti, Hf, Zr, Nb, Ce, or Mg. When the conductive paste is sintered, a nitrogen compound containing at least one of Ti, Hf, Zr, Nb, Ce, and Mg is formed at the interface between the conductive member 28 and the inner lateral surfaces of the aperture 23, so that the adhesion between the conductive member 28 and the inner lateral surfaces of the aperture 23 can be improved. On the other hand, in the case in which the ceramic substrate 20 is made of aluminum nitride, irradiating the ceramic substrate 20 with laser light to form apertures 23 therein may cause aluminum to precipitate on the irradiated surface. Therefore, when the ceramic substrate 20 is made of aluminum nitride and a conductive paste containing at least one of Ti, Hf, Zr, Nb, Ce, and Mg is used as a material of the conductive member 28, the conductive paste may be sintered after the precipitated aluminum is removed. Accordingly, a nitrogen compound containing at least one of Ti, Hf, Zr, Nb, Ce, and Mg is formed at the interface between the conductive member 28 and the inner lateral surfaces of the apertures 23, so that the adhesion between the conductive member 28 and the inner lateral surfaces of the apertures 23 can be improved. In addition, the heat that is transmitted from the conductive member 28 to the ceramic contained in the substrate 2 through the inner lateral surfaces of the apertures 23 can be discharged efficiently.

### VARIATIONS

Next, variations of the method of producing a substrate will be described. Note that the same names, reference numerals, and characters as those in the above-described embodiment will be used to indicate components that are the same as or similar to components as in the above embodiment, and their detailed description will be omitted as appropriate. This will also apply to the examples that will be described later.

### FIRST VARIATION

The first variation differs from the above-described embodiment in that the second laser light 52 is irradiated on the first surface 21 in the second processing step.

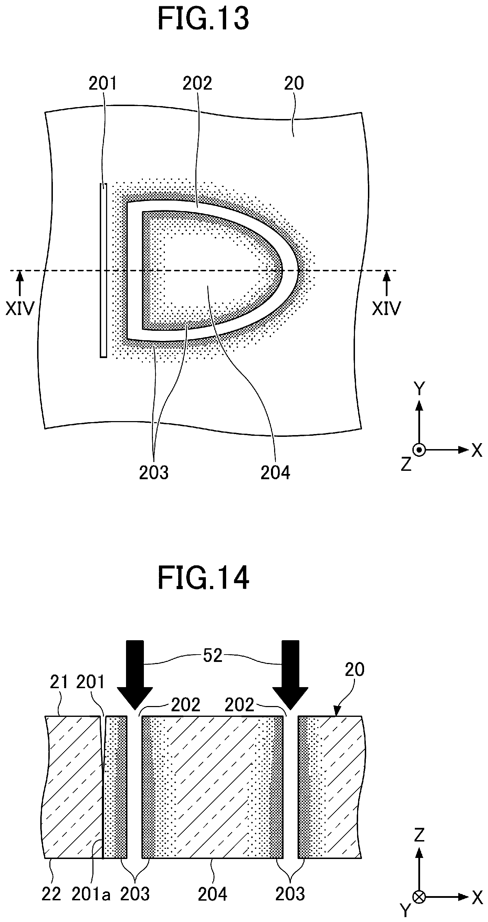

FIG. 13 is a schematic top view of the ceramic substrate 20, illustrating the second processing step in the method of producing a substrate according to the first variation. FIG. 14 is a schematic cross-sectional view taken along line XIV-XIV in FIG. 13. Note that, in the cross-sectional view of FIG. 14, the third part 203 is represented by the same hatching as in the top view of FIG. 13, for ease of understanding.

As illustrated in FIG. 13 and FIG. 14, in the present variation, the second part 202, located apart from the first part 201, on the first surface 21 is irradiated with the second laser light 52. In the examples illustrated in FIG. 13 and FIG. 14, in a plan view, the second part 202 is an annular part of a substantially semi-elliptical shape, which is obtained by cutting an ellipse, whose longitudinal direction coincides the X direction, substantially in half in the longitudinal direction. Also, the second part 202 extends from the first surface 21 and reaches the second surface 22 in the Z direction. The second part 202 not only occupies a space in the X-Y plane, but also occupies a space in the Z direction. Note that, as long as the third part 203 extends from the first surface 21 and reaches the second surface 22 in the Z direction, the second part 202 is not required to penetrate from the first surface 21 to the second surface 22.

As in the present variation, when the second laser light 52 is irradiated on the second part 202 in the first surface 21, the second laser light 52 travels from the first surface 21 to the second surface 22. Because the processing energy of laser light decreases in the direction of travel, the opening diameter of an aperture 23 in the second surface 22 is smaller than the opening diameter of the aperture 23 in the first surface 21. However, the present variation provides the same advantages as those of the above-described embodiment. That is, apertures 23 having contours processed with high accuracy can be formed in the first surface 21.

### SECOND VARIATION

A second variation differs from the above-described embodiment mainly in that the first part 201, the second part 202, the third part 203, and the apertures 23 are substantially rectangular in shape in a plan view.

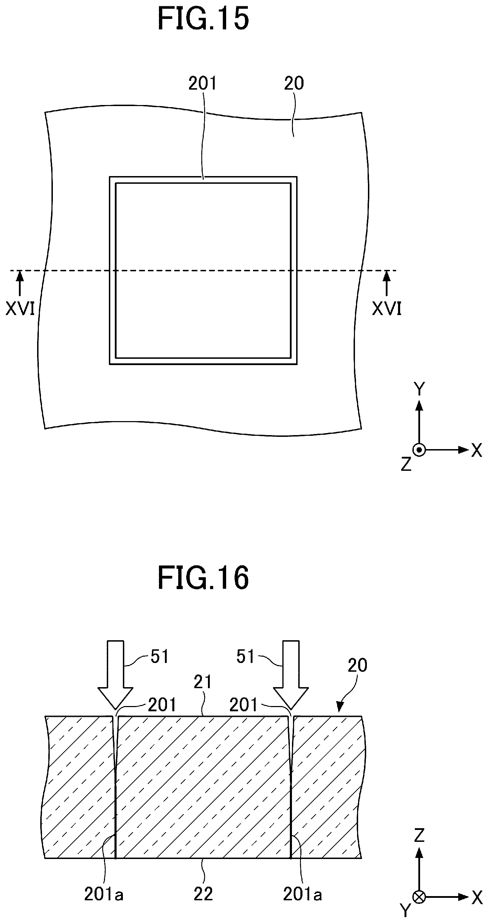

FIG. 15 is a schematic top view of the ceramic substrate 20, illustrating the first part 201 in the method of producing a substrate according to the second variation. FIG. 16 is a schematic cross-sectional view taken along line XVI-XVI in FIG. 15.

In the examples illustrated in FIG. 15 and FIG. 16, the first part 201 is a substantially rectangular, annular part formed in a continuous shape in a plan view. In addition, the first part 201 is an aperture that has a bottom and that does not penetrate from the first surface 21 to the second surface 22 in the Z direction. The first part 201 not only occupies a space in the X-Y plane, but also occupies a space in the Z direction. In the method of producing a substrate according to the present variation, the first part 201 can be ablated by irradiating the first laser light 51 onto the first surface 21 of the ceramic substrate 20, while changing the relative position between the position on which the first laser light 51 is irradiated and the ceramic substrate 20. The first part 201 may be in an intermittent substantially-rectangular annular form in which portions of the first part 201 are separated from each other at locations corresponding to four corners of the substantially rectangular shape in a plan view. By forming the first part 201 in an intermittent shape, the processing time can be shortened.

In the first processing step in the method of producing a substrate according to the present embodiment, the first part 201 has an annular shape, so that all the outer edge of the apertures 23, that is, the surfaces defining the apertures 23 can be formed with high accuracy. Also, in the method of producing a substrate according to the present embodiment, with the first part 201 has a rectangular shape in a plan view, it is possible to form the apertures 23 having a rectangular shape in a plan view.

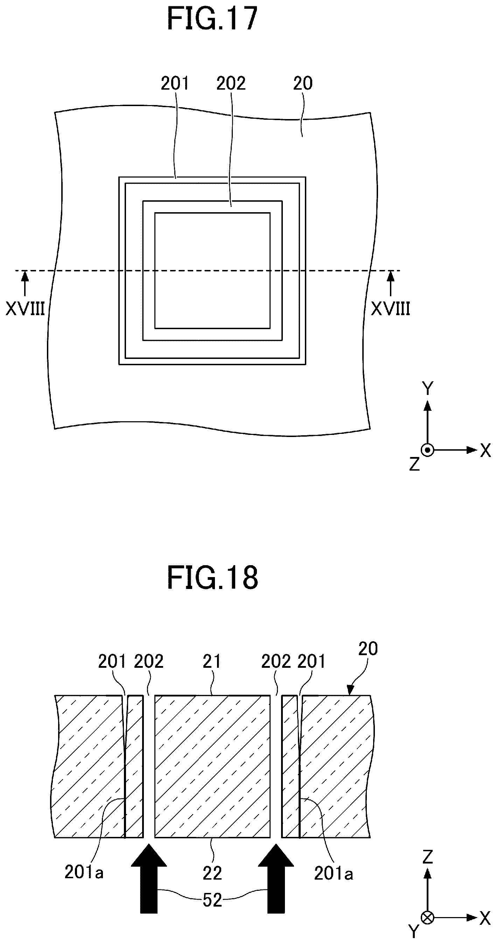

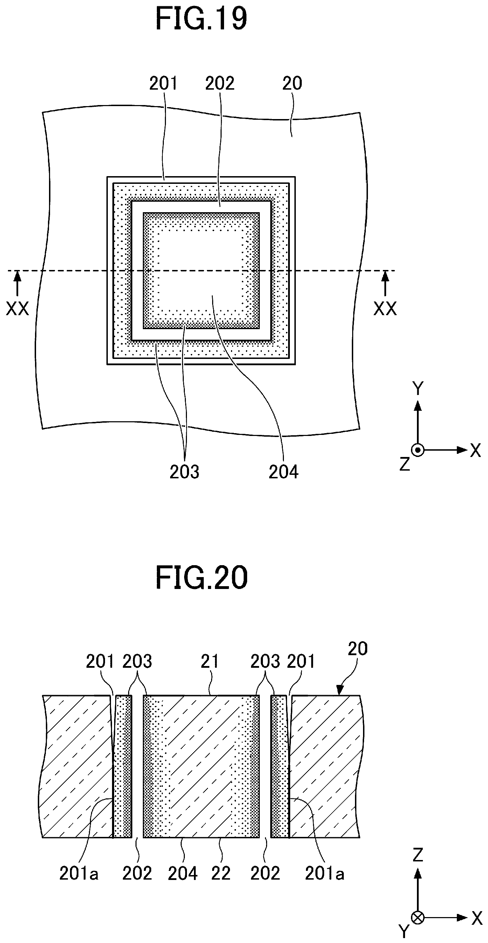

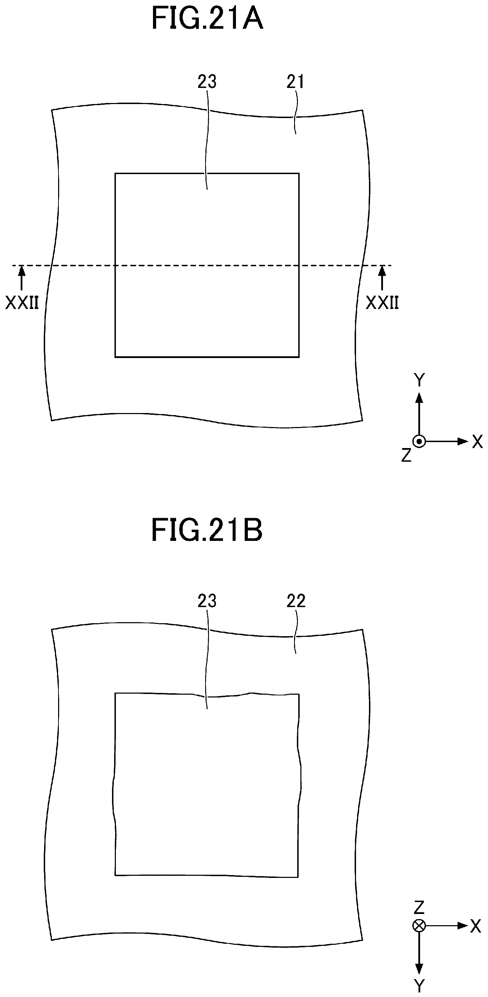

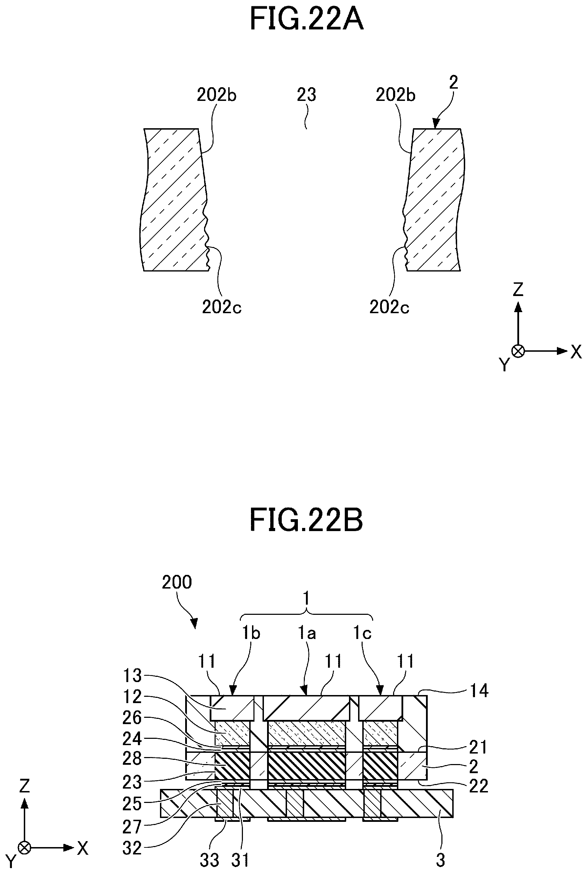

FIG. 17 is a first schematic top view of the ceramic substrate 20, illustrating the second part 202 and the third part 203 in the method of producing a substrate according to the second variation. FIG. 18 is a first schematic cross-sectional view taken along line XVIII-XVIII in FIG. 17. FIG. 19 is a second schematic top view of the ceramic substrate 20, illustrating the second part 202 and third part 203 in the method of producing a substrate according to the second variation. FIG. 20 is a second schematic cross-sectional view taken along line XX-XX in FIG. 19. FIG. 21A is a schematic top view of a substrate, illustrating an aperture 23 formed by the method of producing a substrate according to the second variation. FIG. 21B is a schematic bottom view of a substrate, illustrating an aperture 23 formed by the method of producing a substrate according to the second variation. FIG. 22A is a schematic cross-sectional view taken along line XXII-XXII in FIG. 21A. In the cross-sectional view of FIG. 20, the third part 203 is represented by the same hatching as in the top view of FIG. 19, for ease of understanding. FIG. 22B is a schematic cross-sectional view that illustrates the structure of the light-emitting device 200 with a substrate, according to the second variation.

In the examples illustrated in FIG. 17 and FIG. 18, the second part 202 is a substantially rectangular, annular part in a plan view. Also, the second part 202 is located inward of the first part 201. Furthermore, the second part 202 penetrates from the first surface 21 to the second surface 22 in the Z direction. The second part 202 not only occupies a space in the X-Y plane, but also occupies a space in the Z direction. In the method of producing a substrate according to the embodiment, the second laser light 52 is irradiated on the second surface 22 of the ceramic substrate 20 while changing the relative position between the position on which the second laser light 52 is irradiated and the ceramic substrate 20, thereby thermally processing the second part 202. In the example illustrated in FIG. 22A, the smooth portion 202b is formed in the +Z side of both inner lateral surfaces (for example, the +X side and the -X side) of the aperture 23. Also, the rough portion 202c, in which the surface roughness is reduced, is formed on the -Z side of both inner lateral surfaces of the aperture 23.

By processing the second part 202 and the third part 203 thermally, the part in the ceramic substrate 20 enclosed by the first part 201 can be separated from its surrounding part. Subsequently, by applying a slight vibration or impact such as lifting up the ceramic substrate 20, the substrate 2, from which the part enclosed by the first part 201 has been removed, can be obtained. That is, as illustrated in FIG. 21A, FIG. 21B, and FIG. 22A, an aperture 23 that extends from the first surface 21 to the second surface 22 is formed. When the part enclosed by the second part 202 is small, the third part 203 alone may form the part enclosed by the second part 202. In this case, only the third part 203 is removed. In the examples illustrated in FIG. 21A, FIG. 21B, and FIG. 22A, the aperture 23 is substantially rectangular in shape in a plan view. In the example illustrated in FIG. 21A, in the part where the first part 201 is formed, the contour of the aperture 23 seen from the first surface 21 is shaped substantially rectangular, including a straight line, and therefore is close to the designed rectangular shape, and thus is processed with high accuracy. Also, in the example illustrated in FIG. 21B, the contour of the aperture 23 in the part where the first part 201 is formed, seen from the second surface 22 is linear, which is close to the designed rectangular shape, and thus is processed with relatively high accuracy.

The second pulse width of the second laser light is longer than the first pulse width of the first laser, so that the second part 202 irradiated with the second laser light is wider than the first part 201 irradiated with the first laser. Thus, in the second processing step according to the present variation, the second part 202 is located inward of the first part 201, so that the end positions of the second part 202 expanding from the inside to the outside can be aligned with the end positions of the first part 201 formed outside the second part 202. Accordingly, for example, when end positions of the first part 201 is set as end surfaces of the aperture 23, end surfaces of the aperture 23 can be formed with high accuracy. For example, as illustrated in FIG. 22B, when a conductive member 28 is placed in each aperture 23, where the end surfaces are formed with high accuracy, and used as wiring, it is thus possible to provide a light-emitting device 200, in which the light emitting parts 1 are mounted on the first surface 21 side of the aperture 23 with improved accuracy. Effects and advantages of these variations other than those described above are the same as or similar to those of the embodiment described earlier.

### EXAMPLES

In the description below, an experiment to compare the reflectance of a ceramic substrate and glass, an example 1, an example 2, a reference example, and a comparative example will be illustrated. The present disclosure is not limited to these examples.

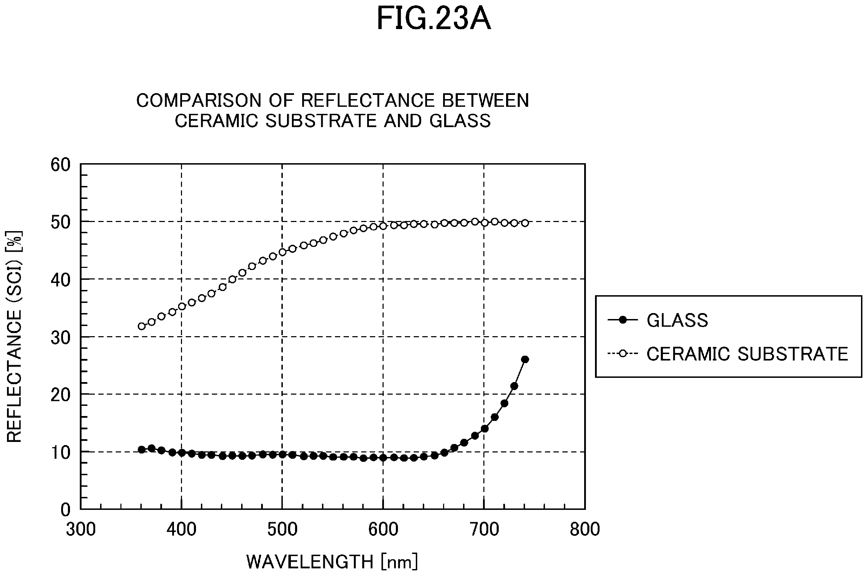

First, an experiment was carried out to confirm the difference between a ceramic substrate and glass in reflectance. The ceramic substrate used in this experiment was one made of silicon nitride and having a thickness of 0.32 mm. Also, the glass was 5 mm-thick and contained silica (SiO₂), soda ash (Na₂O), and lime (CaO) as its main components. In this experiment, the ceramic substrate had a first surface, and a second surface located opposite the first surface. The upper surface of the ceramic substrate corresponds to the "first surface." The lower surface of the ceramic substrate corresponds to the "second surface." Also, the glass had a first surface, and a second surface located opposite the first surface. The upper surface of the glass corresponds to the "first surface." The lower surface of the glass corresponds to the "second surface." The reflectance of the ceramic substrate and the glass was measured by using SpectraMagic (of KONICA MINOLTA JAPAN, INC.), by focusing on the first surface of each and measuring the reflectance of laser light having a wavelength between 360 nm and 740 nm, inclusive. FIG. 23A shows the result.

As illustrated in FIG. 23A, the light transmittance of the glass was approximately 10% when the wavelength was in the range between 360 and 680 nm, inclusive, and approximately 26% when the wavelength was in the range between 680 nm and 740 nm, inclusive; that is, both values were low. On the other hand, the light reflectance of the ceramic substrate was 30% or higher at all wavelengths. This result indicated that light reflectance of the ceramic substrate was higher than that of glass. In other words, the light transmittance of the ceramic substrate was lower than that of glass. Therefore, it is thought to be difficult to focus laser light on a specific point inside the ceramic substrate. Accordingly, irradiating with the first and second laser such that these lasers are focused on the first surface or the second surface, as described in the embodiment illustrated above, is efficient in laser processing of the ceramic substrate.

Table 1 shows main specifications of the first laser light 51 and the second laser light 52 used in the respective methods of producing substrates according to example 1, example 2, the reference example, and the comparative example. The ceramic substrate used in the methods of example 1, example 2, the reference example, and the comparative example was a 150 um-thick silicon nitride.

**[Table 1]**

| | FIRST LASER LIGHT | SECOND LASER LIGHT |
|---|---|---|
| LASER LIGHT SOURCE | FIBER LASER "Lodestone" OF ESI, INC. | GAS LASER "Geode" OF ESI, INC. |
| LASER BEAM DIAMETER | 12~15 *µ*m | 50 *µ*m |
| PEAK WAVELENGTH | 515 nm | 9.4 *µ*m |
| LASER OUTPUT | 12 W OR BELOW | 715 W OR BELOW |

In example 1, the first laser light 51 and the second laser light 52 were combined to form fifty individual apertures 23 by the method of producing a substrate according to the above-described embodiment. To be more specific, the first laser light 51 was irradiated onto the first surface 21 of the ceramic substrate 20 to ablate each first part 201. Then, the second laser light 52 was emitted on the second surface 22 of the ceramic substrate 20 to thermally process each third part 203 including a corresponding first part 201 and second part 202. As a result, the third part 203 and a corresponding fourth part 204 that was enclosed by the third part 203 were separated from the ceramic substrate 20. The separation of third part 203 and the fourth part 204 enclosed by the third part 203 thus formed an aperture 23 that extended from the first surface 21 to the second surface 22.

In example 2, fifty apertures 23 were formed by combining the first laser light 51 and the second laser light 52 using the method of producing a substrate according to the first variation described above. To be more specific, the first laser light 51 was emitted on the first surface 21 of the ceramic substrate 20 to ablate each first part 201. Then, the second laser light 52 was emitted on the first surface 21 of the ceramic substrate 20 to thermally process each third part 203 including a corresponding first part 201 and second part 202. As a result, the third part 203 and a corresponding fourth part 204 that was enclosed by the third part 203 were separated from the ceramic substrate 20. The separation of the third part 203 and the fourth part 204 enclosed by the third part 203 thus formed an aperture 23 that penetrated from the first surface 21 to the second surface 22.

In the reference example, fifty apertures 23 were formed using only the first laser light 51. To be more specific, the first laser light 51 was irradiated on the first surface 21 of the ceramic substrate 20, and an annular part that corresponded to the outer edges of an aperture 23 and extended from the first surface 21 to the second surface 22 was formed by ablation, thereby separating the part enclosed by the annular part from the ceramic substrate 20. The separation of annular part and the part enclosed by the annular part thus formed each aperture 23.

In the comparative example, fifty apertures 23 were formed using only the second laser light 52. To be more specific, the second laser light 52 was emitted on the first surface 21 of the ceramic substrate 20, and an annular part that corresponded to the outer edges of an aperture 23 and penetrated from the first surface 21 to the second surface 22 was formed by thermal processing, thereby separating the part enclosed by the annular part from the ceramic substrate 20. The separation of the annular part and the part enclosed by the annular part thus formed each of the apertures 23.

### RESULT OF FORMATION OF APERTURES 23

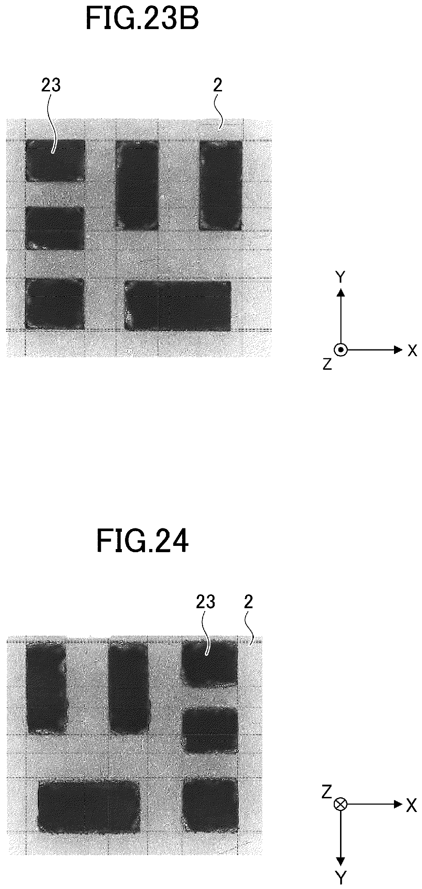

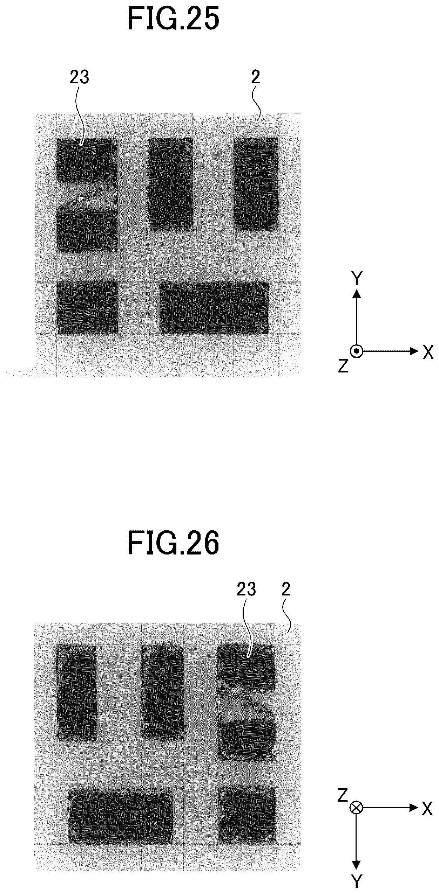

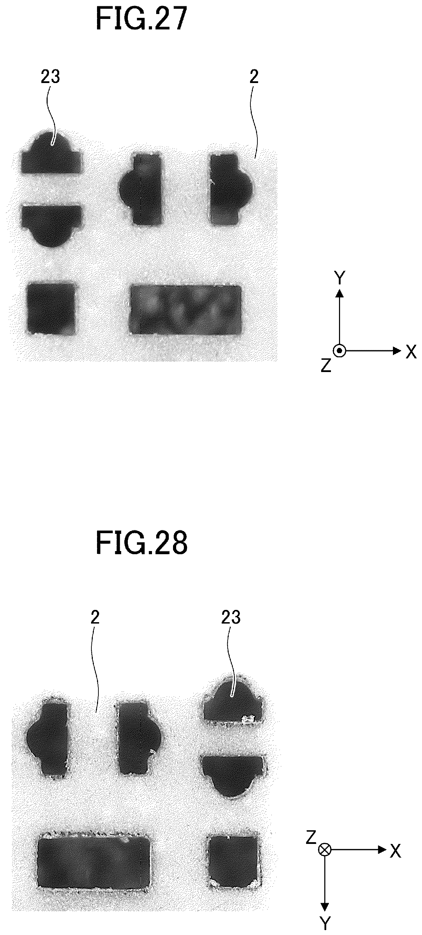

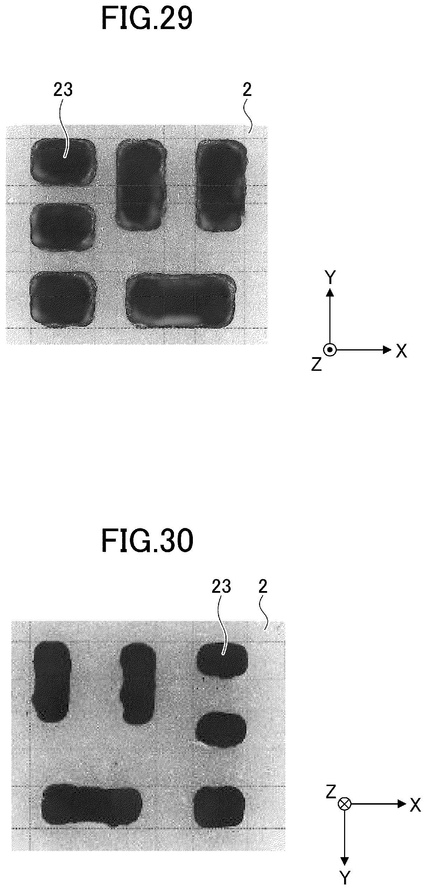

With reference to FIG. 23B to FIG. 30, the respective results of forming apertures 23 using the methods of producing a substrate according to example 1, example 2, the reference example, and the comparative example will be described below. FIG. 23B and FIG. 24 are photographs of apertures 23 formed by the method of producing a substrate according to example 1. FIG. 23B is a top-view photograph of apertures 23 and shows the first surface 21. FIG. 24 is a bottom-view photograph of apertures 23 and shows the second surface 22. FIG. 25 and FIG. 26 are photographs of apertures 23 formed by the method of producing a substrate according to example 2. FIG. 25 is a top-view photograph of apertures 23, and FIG. 26 is a bottom-view photograph of apertures 23. FIG. 27 and FIG. 28 are photographs of apertures 23 formed by the method of producing a substrate according to the reference example. FIG. 27 is a top-view photograph of apertures 23, and FIG. 28 is a bottom-view photograph of apertures 23. FIG. 29 and FIG. 30 are photographs of apertures 23 formed by the method of producing a substrate according to the comparative example. FIG. 29 is a top-view photograph of the apertures 23, and FIG. 30 is a bottom-view photograph of apertures 23. FIG. 23B to FIG. 30 shows images of apertures 23 formed in the ceramic substrate 20, photographed by a camera.

The examples illustrated in FIG. 23B to FIG. 30 each show six apertures 23, out of fifty apertures 23, formed by the methods of producing a substrate according to example 1, example 2, the reference example, and the comparative example. As shown in FIG. 23B to FIG. 28, in example 1, example 2, and the reference example, the apertures 23 were formed with distinct contours. In particular, the apertures 23 in the first surface 21, which was ablated by the first laser light 51, had more distinct contours. The straight-line parts of the apertures 23 in the first surface 21 were formed with good linearity. The corners of the apertures 23 in the first surface 21 were substantially right angles. On the other hand, in the comparative example, the straight parts of the apertures 23 were winding, and the linearity was not as good compared to example 1, example 2, or the reference example. Moreover, the corners of the apertures 23 were formed as curved surfaces.

Table 2 below shows a list of the respective results of evaluation of formation of apertures 23 in each example.

**[Table 2]**

| | SHAPE OF CORNER | SHAPE OF STRAIGHT PART | DIFFERENCE BETWEEN FRONT AND BACK IN SIZE | DAMAGE ON SUBSTRATE | PROCESSING TIME |
|---|---|---|---|---|---|
| EXAMPLE 1 | ○ | ⊚ | -3.7% OR GREATER +4.7% OR LESS | ○ | 3.8 SECONDS |
| EXAMPLE 2 | ○ | ⊚ | -8.7% OR GREATER +9.0% OR LESS | ○ | 3.8 SECONDS |
| REFERENCE EXAMPLE | ⊚ | ⊚ | -1.6% OR GREATER +2.2% OR LESS | ○ | 14.0 SECONDS |
| COMPARATIVE EXAMPLE | × | × | +25% OR LESS | × | 1.2 SECONDS |

In the evaluations set forth in Table 2, multiple apertures 23 including apertures having a substantially round shape and apertures having a substantially rectangular shape in a plan view were formed by the methods of producing a substrate according to example 1, example 2, the reference example, and the comparative example. The size of an aperture 23 in a plan view was between 0.1 mm and 0.4 mm, inclusive, when the aperture 23 was substantially rectangular.
Its diameter was between 0.06 mm and 0.3 mm, inclusive, when the aperture 23 was substantially round. The number of apertures 23 was 50.

In the evaluation results of Table 2, "⊚" indicates that the substrate is in good condition. "○" indicates that the substrate is fit for use. "×" indicates that the substrate is not fit for use. Note that these symbols/expressions in evaluation results will be the same throughout the rest of the evaluation results shown hereinafter.

In the evaluation items in Table 2, "Shape of corners" indicates the shape of corners in the apertures 23; the closer to a right angle a corner is, the better the evaluation result. "Shape of straight parts" indicates the shape of straight parts in the apertures 23; the more linear a straight part is, the better the evaluation result. "Shape of corners" and "shape of straight parts" were evaluated by observing each part's appearance through a microscope and judging the result visually. "Difference between front and back in size" means the difference in size between apertures 23 formed on the first surface 21 (front surface) and apertures 23 formed on the second surface 22 (back surface). "Difference between front and back in size" is expressed as the percentage of error with respect to the design values of dimensions, where a positive value indicates that the size is larger than the design value and a negative value indicates that the size is smaller than the design value. "Processing time" is the time required until all the apertures 23 are formed.

As shown in Table 2, in the reference example, good results were obtained in each of evaluation items "shape of corners," "shape of straight parts," "difference between front and back in size," and "damage on substrate." On the other hand, "processing time" was 14.0 seconds, which was longer than in any other example. From these results, it was found that the reference example allowed the apertures 23 to be formed with high accuracy, and was therefore advantageous when, for example, the processing time was not limited.

In the comparative example, the processing time was 1.2 seconds, which was shorter than in any other example. On the other hand, the evaluation items "shape of corners," "shape of straight parts," "difference between front and back in size," and "damage on substrate" all showed levels (values) where the substrate was not fit for use. To be more specific, the radius of curvature of corners was approximately 25 um. Also, the meandering width of the straight parts was 12 um at a maximum. It was found that the comparative example allowed the apertures 23 to be formed with excellent productivity, but the accuracy of formation of apertures 23 was lower than in any other example. In the present specification, "the substrate is not fit for use" indicates that, assuming that a conductive member is placed in each aperture formed in the substrate and a light-emitting element is mounted over the aperture, the light-emitting element is likely to deviate from its planned mounting position.

In example 1 and example 2, all of the evaluation items, namely "shape of corners," "shape of straight parts," "difference between front and back in size," and "damage on substrate" showed good results. The processing time was 3.8 seconds, which was approximately 1/4 of that of the reference example and was close to that of the comparative example. These results showed that the apertures 23 was able to be formed with high accuracy and productivity in examples 1 and 2. In other words, it was found that, according to example 1 and example 2, both high accuracy and high productivity was able to be achieved in formation of apertures 23.

### EXAMPLE OF RESULT OF FORMING APERTURES 23 USING THE METHOD OF PRODUCING A SUBSTRATE ACCORDING TO EXAMPLE 1

The formation of apertures 23 by the method of producing a substrate according to example 1 will be described in more detail.

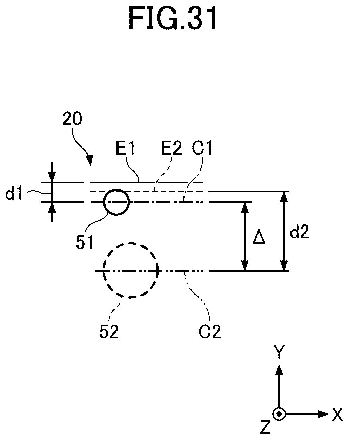

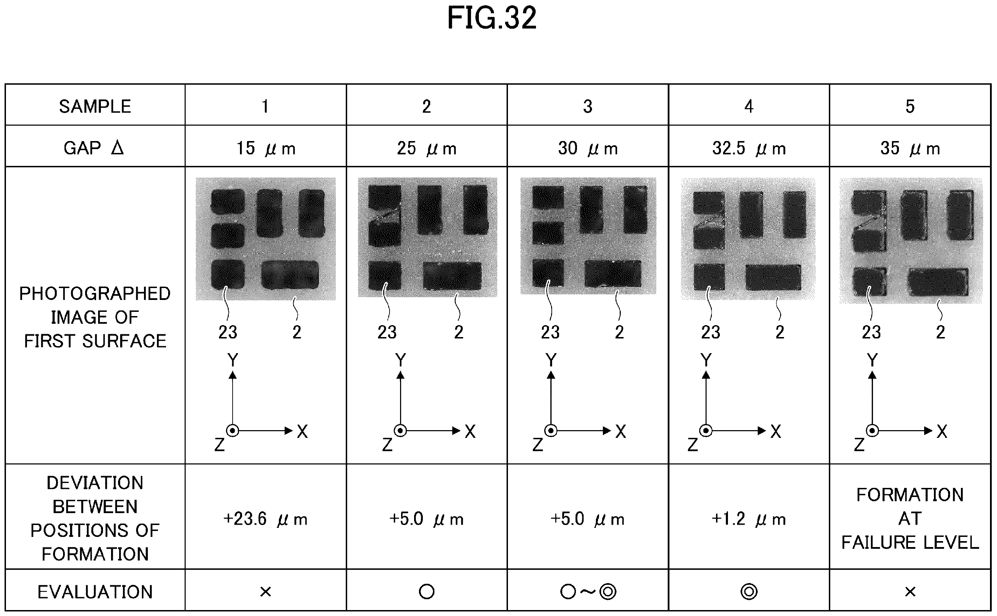

With reference to samples 1 to 5 in FIG. 31 and FIG. 32, the influence of the gap between the first part 201 and the second part 202 on the accuracy of formation of apertures 23 will be described.

FIG. 31 is a schematic diagram for explaining the gap between the first part 201 and the second part 202. FIG. 31 shows, in a plan view, the first laser light 51 irradiated on a surface of the ceramic substrate 20 at the +Z side (the first surface 21 illustrated in FIG. 4) and the second laser light 52 irradiated on the surface of the ceramic substrate 20 at the -Z side (the second surface 22 illustrated in FIG. 4). The first laser light 51 and the second laser light 52 in FIG. 31 represent respective laser beam diameters irradiated on the ceramic substrate 20. The laser beam diameter of the first laser light 51 was 15 um. The beam spot diameter of the second laser light 52 was 50 um.

In FIG. 31, C1 is the first axis of movement, representing the path of movement of the center of the first laser light 51, showing its movement relative to the ceramic substrate 20. C2 is the second axis of movement, representing the path of movement of the center of the second laser light 52, showing its movement relative to the ceramic substrate 20. Δ represents the gap between the first axis of movement C1 and the second axis of movement C2. The gap Δ is the distance between the first part formed by the first laser light 51 and the second part formed by the second laser light 52. Also, the gap Δ corresponds to the third part 203. In other words, the gap Δ is the shortest distance between the center of the first part and the center of the second part. According to the method of producing a substrate of the present embodiment, it is possible to form multiple apertures 23 such that the distance between centers of adjacent apertures 23 is between 100 um and 500 um, inclusive.

In FIG. 31, a first end plane E1 represents a plane of an end of a portion subject to ablation by the first laser light 51. A second end plane E2 represents a plane of an end of a portion subject to thermal processing by the second laser light 52. In the thermal processing using the second laser light 52, the processed part is wider due to heat, compared to the part ablated by the first laser light 51. Therefore, the second distance d2 between the second axis of movement C2 and the second end plane E2 is greater than the first distance d1 between the first axis of movement C1 and the first end plane E1.

FIG. 32 is a diagram that shows the relationship between the gap Δ between the first part 201 and the second part 202, and the deviation between positions of formation. As shown in FIG. 32, in samples 1 to 5, the first laser light 51 and the second laser light 52 were irradiated at different gaps Δ. "Photographed image of first surface" shows images of apertures 23 formed in the ceramic substrate 20 at the gap Δ of each sample, photographed from the first surface 21 side. "Deviation between positions of formation" is the maximum amount by which the positions of end surfaces of each aperture 23, formed in the ceramic substrate 20 at the gap Δ of each sample, deviate from the design position of each aperture 23, that is, the maximum error in the formation of end surfaces of apertures 23.

As shown in FIG. 32, given the ceramic substrate 20, when the gap Δ was in the range between 25.0 um and 32.5 µm, inclusive, the deviation between positions of formation was less than or equal to +5.0 um, and the evaluation result was "⊚" or "○." It was found that, from the perspective of forming the apertures 23 with high accuracy, the gap Δ is preferably between 25.0 um and 32.5 µm, inclusive, more preferably between 30.0 um or more and 32.5 um, inclusive, and, even more preferably, is 32.5 µm.

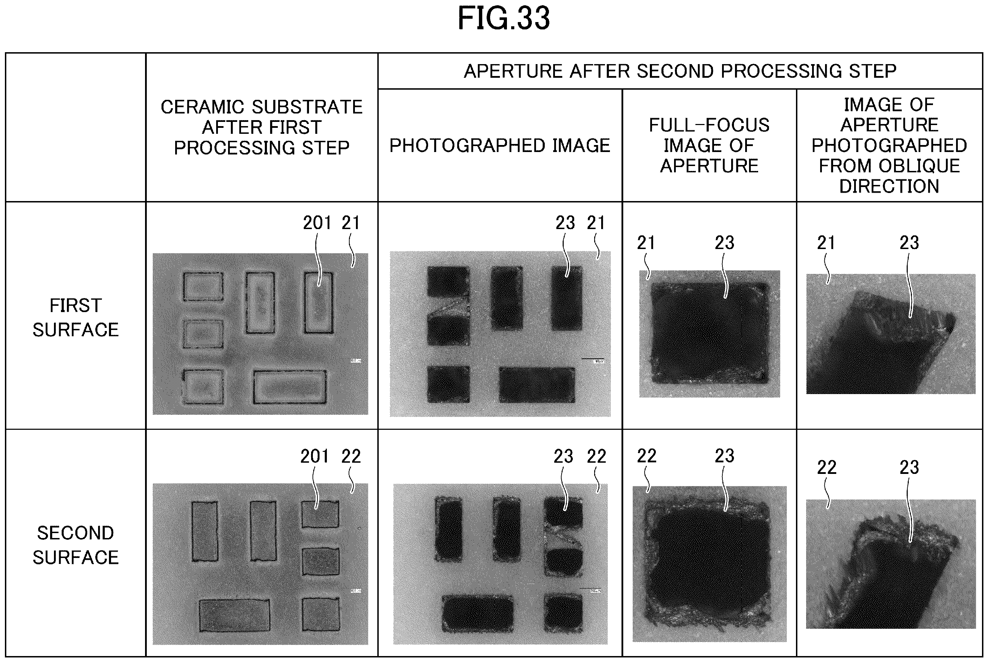

FIG. 33 shows photographs of the ceramic substrate 20 having been subjected to the first processing step in the method of producing a substrate according to example 1, taken from the first surface 21 side and the second surface 22 side. FIG. 33 shows photographs of apertures 23 formed after the second processing step in the method of producing a substrate according to example 1, taken from the first surface 21 side and the second surface 22 side. In the example shown in FIG. 33, the gap Δ in FIG. 31 was set to 32.5 µm.

As shown in FIG. 33, in the first processing step, the first part 201 was formed in the first surface 21 by ablation. As can be seen from the photographs of the second surface 22 of the ceramic substrate 20 taken after the first processing step, the ablation-induced alteration of the properties of the ceramic substrate in the first surface 21 extended to the second surface 22. However, in the state in which the first processing step is finished, the part enclosed by the first part 201 was not separated from a part around it.

In the second processing step, apertures 23 were formed in the ceramic substrate 20 by thermal processing. In the example shown in FIG. 33, the second laser light was irradiated from the second surface 22 side for thermal processing. Therefore, as shown by the full-focus images of an aperture 23 in FIG. 33 and the images of an aperture 23 photographed from an oblique direction, the apertures 23 formed on the second surface 22 had end surfaces that were uneven and rough, compared to the end surfaces of the apertures 23 formed on the first surface 21. This showed that the shape of the first part 201 formed by ablation was accurate compared to the second part 202 and the third part 203 illustrated in FIG. 9, FIG. 10, etc. that were formed by thermal processing.

As for the apertures 23 formed by the method of producing a substrate according to example 1, the surface roughness of smooth portions 202b, which corresponded to the V-shaped recess in the first part 201, and the surface roughness of rough portions 202c, which were formed on the -Z side of both inner lateral surfaces of each aperture 23 and in which the surface roughness was reduced, were measured using a scanning electron microscope (SEM). The apertures 23 were washed by wet blasting before the surface roughness was measured. As a result, in the smooth portions 202b of the inner lateral surfaces of the apertures 23, Sa was 1.08 um and Sz was 5.71 um. On the other hand, in the rough portions 202c, Sa was 2.45 um and Sz was 20.08 um. As used herein, "Sa" is the arithmetic mean height, and "Sz" is the maximum height. As a result, it was found out that the smooth portions 202b and the rough portions 202c varied in surface roughness, and that the smooth portions 202b had less surface roughness than the rough portions 202c.

Although certain embodiments and a number of examples have been described in detail above, the present invention is not limited to these, and a variety of changes and substitutions are applicable to the above-described embodiment and examples within the scope of the accompanying claims.

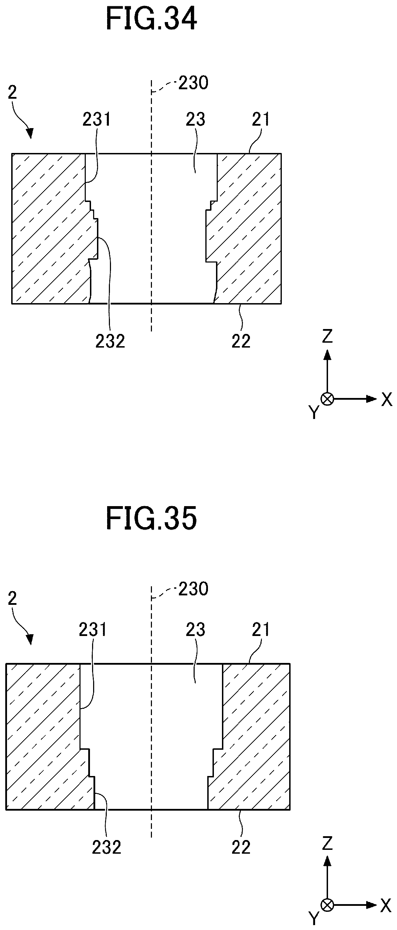

For example, the inner lateral surfaces of the apertures 23 can have a variety of shapes. FIG. 34 and FIG. 35 are each a cross-sectional view of an aperture 23 for explaining the shape of the inner lateral surfaces of the aperture 23. FIG. 34 shows a first example, and FIG. 35 shows a second example. FIG. 34 and FIG. 35 both show a cross-section of an aperture 23 in the Z direction, cut in an imaginary plane where the center axis 230 of the aperture 23 is located.

In FIG. 34 and FIG. 35, the first inner lateral surface 231 is the inner lateral surface with the largest opening among the inner lateral surfaces of the aperture 23. The second inner lateral surface 232 is the inner lateral surface with the smallest opening among the inner lateral surfaces of the aperture 23.

In the example illustrated in FIG. 34, the first inner lateral surface 231 is located on the first surface 21 side. Also, the second inner lateral surface 232 is located between the first surface 21 and the second surface 22. In the aperture 23, the first inner lateral surface 231 has lower surface roughness and therefore is smoother than the second inner lateral surface 232. The aperture 23 illustrated in FIG. 34 can be formed by irradiating the second part of the second surface 22 with the second laser light 52 in the second processing step. When the second laser light 52 is irradiated on the second part 202 of the second surface 22, the second laser light 52 travels from the second surface 22 to the first surface 21. The processing energy of the laser light decreases in the direction of travel. On the second surface 22 irradiated with the second laser light 52, the processing energy of the laser light is sufficiently high. However, where the processing energy of the laser light becomes low, a second inner lateral surface 232 having a rougher surface than the first inner lateral surface 231 and including protrusions is formed. The aperture 23 illustrated in FIG. 34 has a second inner lateral surface 232 located apart from the first surface 21 and the second surface 22, so that the contours (that is, the accuracy of processing) of apertures 23 on the first surface 21 and the second surface 22 is not affected. Therefore, when it is desirable to obtain apertures 23 having contours processed with high accuracy on both the first surface 21 and the second surface 22, it is preferable to emit the second laser light 52 from the second surface 22 side.

On the other hand, in the example illustrated in FIG. 35, the first inner lateral surface 231 is located on the first surface 21 side. Also, the second inner lateral surface 232 is located on the second surface 22 side. Therefore, in the example illustrated in FIG. 35, in the aperture 23, its opening is larger at the first surface 21 than at the second surface 22. In this aperture 23, the surface roughness of the first inner lateral surface 231 is lower and smoother than the surface roughness of the second inner lateral surface 232. The aperture 23 illustrated in FIG. 35 can be formed by irradiating the second part of the first surface 21 with the second laser light 52 in the second processing step. When the second laser light 52 is irradiated on the second part 202 on the first surface 21, the laser light of the second laser light 52 travels from the first surface 21 to the second surface 22. Because the processing energy of laser light decreases in the direction of travel, the opening diameter of the aperture 23 at the second surface 22 is smaller than the opening diameter of the aperture 23 at the first surface 21, and, in the cross-section of the aperture 23 including the first surface 21 and the second surface 22, protrusions are formed on the second inner lateral surface 232 of the aperture 23 on the second surface 22 side, with the second inner lateral surface 232 rougher than the first inner lateral surface 231. However, even with the aperture 23 illustrated in FIG. 35, it is still possible to process its contour with high accuracy in the first surface 21.

The method of producing a substrate according to the present disclosure makes it possible to form apertures that penetrate a ceramic substrate with high accuracy, and therefore is suitable for use when producing ceramic substrates that are used in light-emitting devices for, for example, in-vehicle light sources, light sources for lighting, light sources for a variety of indicators, light sources for displays, light sources for LCD backlights, traffic lights, in-vehicle components, and channel letters for signs. However, the method of producing a substrate according to the present disclosure is in no way limited to the process of producing ceramic substrates used in light-emitting devices, and can be applied to the process of producing ceramic substrates for a variety of uses.

The present disclosure include, for example, the following aspects:

### ASPECT 1

A method of producing a substrate, including:
providing a ceramic substrate having a first surface and a second surface that is located opposite the first surface;
irradiating a first part of the first surface with a first laser light having a first pulse width to perform ablation of the first part of the ceramic substrate; and
irradiating a second part of either the first surface or the second surface with a second laser light having a second pulse width, which is longer than the first pulse width, the second part being located apart from the first part in a plan view to perform thermal processing of a third part including the first part and the second part,
wherein, upon removal of the third part and a part enclosed by the third part, an aperture that extends from the first surface to the second surface is formed in the ceramic substrate.

### ASPECT 2

The method according to Aspect 1, in which, when the ablation is performed, the first part has an annular shape.

### ASPECT 3

The method according to Aspect 2, in which, when the thermal processing is performed, the second part is located inward of the first part.

### ASPECT 4

The method according to Aspect 3, in which, in the ceramic substrate, a distance between the first part and the second part is between 25.0 um and 32.5 µm, inclusive.

### ASPECT 5

The method according to any one of Aspect 1 to Aspect 4, in which the second part is located on the second surface.

### ASPECT 6

The method according to any one of Aspect 1 to Aspect 5, in which, when the ablation is performed, the first part extends from the first surface and reaches the second surface.

### ASPECT 7

The method according to any one of Aspect 1 to Aspect 6, in which, when the thermal processing is performed, the second part has an annular shape.

### ASPECT 8

The method according to any one of Aspect 1 to Aspect 7, in which the first part is rectangular in shape in a plan view.

### ASPECT 9

The method according to any one of Aspect 1 to Aspect 8, in which:
the first laser light has a pulse width in a femto-second range; and
the second laser light is emitted from a CO₂ laser light source.

### ASPECT 10

The method according to any one of Aspect 1 to Aspect 9, in which a thickness of the ceramic substrate is between 100 um and 500 um, inclusive.

### ASPECT 11

The method according to any one of Aspect 1 to Aspect 10, in which the ceramic substrate is made of silicon nitride.

### ASPECT 12

The method according to any one of Aspect 1 to Aspect 11, further including placing a conductive paste in the aperture and firing the conductive paste, thereby forming a conductive member.

### ASPECT 13

The method according to Aspect 12, in which the conductive paste contains at least one of Ti, Hf, Zr, Nb, Ce, or Mg.

## Claims

1. A method of producing a substrate, comprising:
providing a ceramic substrate having a first surface and a second surface that is located opposite the first surface;
irradiating a first part of the first surface with a first laser light having a first pulse width to perform ablation of the first part of the ceramic substrate; and
irradiating a second part of either the first surface or the second surface with a second laser light having a second pulse width, which is longer than the first pulse width, the second part being located apart from the first part in a plan view to perform thermal processing of a third part including the first part and the second part,
wherein, upon removal of the third part and a part enclosed by the third part, an aperture that extends from the first surface to the second surface is formed in the ceramic substrate.

2. The method according to claim 1, wherein, when the ablation is performed, the first part has an annular shape.

3. The method according to claim 2, wherein, when the thermal processing is performed, the second part is located inward of the first part.

4. The method according to claim 3, wherein, in the ceramic substrate, a distance between the first part and the second part is between 25.0 um and 32.5 um, inclusive.

5. The method according to claim 1 or claim 2, wherein the second part is located on the second surface.

6. The method according to claim 1 or claim 2, wherein, when the ablation is performed, the first part extends from the first surface and reaches the second surface.

7. The method according to claim 1 or claim 2, wherein, when the thermal processing is performed, the second part has an annular shape.

8. The method according to claim 1 or claim 2, wherein the first part is rectangular in shape in a plan view.

9. The method according to claim 1 or claim 2,
wherein the first laser light has a pulse width in a femto-second range, and
wherein the second laser light is emitted from a CO₂ laser light source.

10. The method according to claim 1 or claim 2, wherein a thickness of the ceramic substrate is between 100 um and 500 um, inclusive.

11. The method according to claim 1 or claim 2, wherein the ceramic substrate is made of silicon nitride.

12. The method according to claim 1 or claim 2, further comprising placing a conductive paste in the aperture and firing the conductive paste, thereby forming a conductive member.

13. The method according to claim 12, wherein the conductive paste contains at least one of Ti, Hf, Zr, Nb, Ce, or Mg.
